(19) Europäisches Patentamt
European Patent Office
Office européen des brevets

(11) EP 4 175 010 A1

(12) EUROPEAN PATENT APPLICATION
published in accordance with Art. 153(4) EPC

(43) Date of publication:
**03.05.2023 Bulletin 2023/18**

(21) Application number: **21829830.5**

(22) Date of filing: **18.06.2021**

(51) International Patent Classification (IPC):
***H01M 10/48*** *(2006.01)*

(52) Cooperative Patent Classification (CPC):
**H01M 10/48;** Y02E 60/10

(86) International application number:
**PCT/JP2021/023213**

(87) International publication number:
**WO 2021/261402 (30.12.2021 Gazette 2021/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.06.2020 JP 2020110549**

(71) Applicant: **GS Yuasa International Ltd.**
**Kisshoin, Minami-ku,**
**Kyoto-shi, Kyoto 601-8520 (JP)**

(72) Inventor: **OJI, Katsuya**
**Kyoto-shi, Kyoto 601-8520 (JP)**

(74) Representative: **Grünecker Patent- und Rechtsanwälte**
**PartG mbB**
**Leopoldstraße 4**
**80802 München (DE)**

# (54) TEMPERATURE ESTIMATION DEVICE, COMPUTER PROGRAM, AND TEMPERATURE ESTIMATION METHOD

(57) A temperature estimation device includes: a charge-discharge data acquisition unit that acquires charge-discharge data relating to charge-discharge of an energy storage device; an environmental temperature data acquisition unit that acquires temperature data relating to an environmental temperature of a battery board accommodating a plurality of the energy storage devices; and a temperature estimation unit that calculates an ambient temperature of the energy storage device in the battery board using the charge-discharge data and the temperature data, and estimates a temperature of the energy storage device using the calculated ambient temperature and the charge-discharge data.

Fig. 6

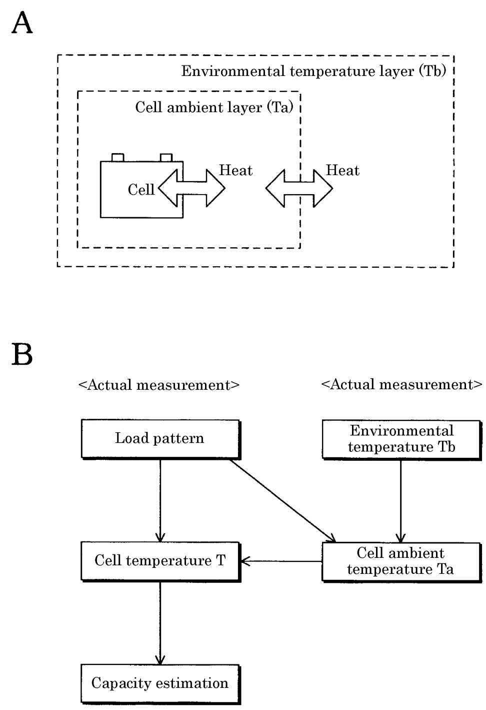


EP 4 175 010 A1

## Description

### TECHNICAL FIELD

The present invention relates to a temperature estimation device, a computer program, and a temperature estimation method.

### BACKGROUND ART

A power storage system is used for an uninterruptible power system, a stabilized power supply, and the like, and is also used as a large-scale device that stores renewable energy or power generated by an existing power generating system. In recent years, the power storage system is used not only for an industrial stationary application but also a power source for a moving body such as a hybrid vehicle and an electric vehicle.

The power storage system includes one or a plurality of battery boards. The battery board is configured of a plurality of modules, and the module is configured of a plurality of energy storage devices (cells) connected in series, connected in parallel, or a combination of series and parallel (see Patent Document 1).

### PRIOR ART DOCUMENT

### PATENT DOCUMENT

Patent Document 1: WO 2015/151652

### SUMMARY OF THE INVENTION

### PROBLEMS TO BE SOLVED BY THE INVENTION

A temperature of the energy storage device is a significant factor that greatly affects capacity degradation of the energy storage device. However, when the plurality of energy storage devices are used to assemble a module to incorporate the plurality of modules in the battery board similarly to the system of Patent Document 1, the temperature of each energy storage device incorporated in the battery board tends to be higher than the temperature of the energy storage device alone due to the influence of heat retention in the battery board. For this reason, it is desired that the temperature of the energy storage device incorporated in the battery board is accurately estimated.

An object of the present invention is to provide a temperature estimation device, a computer program, and a temperature estimation method capable of accurately estimating the temperature of the energy storage device incorporated in the battery board.

### MEANS FOR SOLVING THE PROBLEMS

A temperature estimation device includes: a charge-discharge data acquisition unit that acquires charge-discharge data relating to charge-discharge of an energy storage device; an environmental temperature data acquisition unit that acquires temperature data relating to an environmental temperature of a battery board accommodating a plurality of the energy storage devices; and a temperature estimation unit that calculates an ambient temperature of the energy storage device in the battery board using the charge-discharge data and the temperature data, and estimates a temperature of the energy storage device using the calculated ambient temperature and the charge-discharge data.

A computer program causes a computer to execute: acquiring charge-discharge data relating to charge-discharge of an energy storage device; acquiring temperature data relating to an environmental temperature of a battery board accommodating a plurality of the energy storage devices; and calculating an ambient temperature of the energy storage device in the battery board using the charge-discharge data and the temperature data, and estimating a temperature of the energy storage device using the calculated ambient temperature and the charge-discharge data.

A temperature estimation method includes: acquiring charge-discharge data relating to charge-discharge of an energy storage device; acquiring temperature data relating to an environmental temperature of a battery board accommodating a plurality of the energy storage devices; and calculating an ambient temperature of the energy storage device in the battery board using the charge-discharge data and the temperature data, and estimating a temperature of the energy storage device using the calculated ambient temperature and the charge-discharge data.

The charge-discharge data acquisition unit acquires the charge-discharge data relating to the charge-discharge of the energy storage device. The charge-discharge data can be time-series data of a charge current or a discharge current of the energy storage device. The charge-discharge data can be time-series data of an operation period from an operation start to an operation end of the power storage system, and the operation period can be an appropriate period such as one day, one week, two weeks, one month, three months, half a year, one year, or the like depending on the operation state of the power storage system. At this point, the power storage system includes one or a plurality of battery boards. A plurality of modules are disposed in the battery board. The module is configured of a plurality of energy storage devices (cells) connected in series, connected in parallel, or a combination of series and parallel.

The environmental temperature data acquisition unit acquires temperature data relating to the environmental temperature of the battery board accommodating the plurality of energy storage devices. The environmental temperature data can also be time series data of the operation period from a start to an end of the operation of the power storage system. The environmental temperature is a temperature outside the battery board, for example, a temperature of a room in which the battery board is installed, and can be a set temperature set to a required temperature depending on an operation state of the power storage system.

The temperature estimation unit calculates the ambient temperature of the energy storage device in the battery board using the charge-discharge data and the temperature data, and estimates the temperature of the energy storage device using the calculated ambient temperature and the charge-discharge data. The heat retention in the battery board affects the accuracy of the temperature of the energy storage device while the energy storage device is accommodated in the battery board. Accordingly, the temperature in the battery board (the temperature in the heat retention state) is defined as the ambient temperature. The ambient temperature depends on heat generation of the energy storage device, and the calorific value of the energy storage device depends on charge-discharge data of the energy storage device. The ambient temperature depends on heat transfer between the inside and the outside of the battery board, and the heat transfer depends on the temperature data outside the battery board. Accordingly, the ambient temperature can be calculated using the charge-discharge data and the temperature data.

The temperature (for example, a surface temperature of the energy storage device and the like) of the energy storage device depends on the calorific value of the energy storage device, so that the temperature of the energy storage device depends on the charge-discharge data of the energy storage device. The temperature of the energy storage device depends on heat transfer with the periphery of the energy storage device, and the heat transfer depends on the ambient temperature. Accordingly, the temperature of the energy storage device can be calculated using the ambient temperature and the charge-discharge data.

As described above, the influence of heat retention inside the battery board can be simulated by considering the ambient temperature that is the temperature of the periphery of the energy storage device and that is the temperature inside the battery board, and the temperature of the energy storage device incorporated in the battery board can be accurately estimated.

The temperature estimation device may further include: a first temperature variation amount calculation unit that calculates a first temperature variation amount in the battery board, due to heat generation of the energy storage device caused by the charge-discharge, based on the charge-discharge data; a second temperature variation amount calculation unit that calculates a second temperature variation amount in the battery board, due to heat transfer between an environment outside the battery board and an inside of the battery board, based on the temperature data; and an ambient temperature calculation unit that calculates an ambient temperature of the energy storage device in the battery board based on the first temperature variation amount and the second temperature variation amount.

The first temperature variation amount calculation unit may calculate the first temperature variation amount in the battery board, due to heat generation of the energy storage device caused by charge-discharge, based on the charge-discharge data. The internal resistance of the energy storage device is denoted by R, and the heat capacity of the energy storage device is denoted by C. When the current of the energy storage device is denoted by i, the calorific value Q of the energy storage device can be simply expressed by $Q = i^2 \cdot R$, and the first temperature variation amount given to the ambient temperature in the battery board can be calculated using an equation converted into a temperature as in (Q/C).

The second temperature variation amount calculation unit may calculate the second temperature variation amount in the battery board due to heat transfer between the environment outside the battery board and the inside of the battery board based on the temperature data. The environmental temperature outside the battery board is denoted by Tb, and the ambient temperature inside the battery board is denoted by Ta. The second temperature variation amount given to the ambient temperature in the battery board can be calculated using an equation as (Ta - Tb).

The ambient temperature calculation unit may calculate the ambient temperature of the energy storage device in the battery board based on the first temperature variation amount and the second temperature variation amount. Thus, the ambient temperature can be calculated in consideration of both the influence of heat retention due to warming of the air in the battery board by heat generation of the energy storage device and the influence of heat transfer between the inside and the outside of the battery board.

In the temperature estimation device, the first temperature variation amount calculation unit may calculate the first temperature variation amount using an arithmetic expression exponentiating a value, which is obtained by dividing the calorific value of the energy storage device by a heat capacity of the energy storage device, by a first exponent.

The first temperature variation amount calculation unit may calculate the first temperature variation amount using an arithmetic expression $(Q/C)^p$ exponentiating a value (Q/C), which is obtained by dividing the calorific value Q of the energy storage device by the heat capacity C of the energy storage device, by the first exponent p. The first exponent p can vary depending on design conditions such as capacity and structure of the power storage system, so that an appropriate value may be selected depending on the power storage system. Thus, the first temperature variation amount can be calculated regardless of the structure of the power storage system or the like.

In the temperature estimation device, the second temperature variation amount calculation unit may calculate the second temperature variation amount using an arithmetic expression exponentiating a difference between an ambient temperature of the energy storage device and the environmental temperature of the battery board by a second exponent.

The second temperature variation amount calculation unit may calculate the second temperature variation amount using an arithmetic expression $(Ta - Tb)^q$ exponentiating a difference (Ta - Tb) between the ambient temperature Ta of the energy storage device and the environmental temperature Tb of the battery board by the second exponent q. The second exponent q can vary depending on design conditions such as capacity and structure of the power storage system, so that an appropriate value may be selected depending on the power storage system. Thus, the second temperature variation amount can be calculated regardless of the structure of the power storage system or the like.

The temperature estimation device may further include: a third temperature variation amount calculation unit that calculates a third temperature variation amount of the energy storage device, due to the heat generation caused by the charge-discharge, based on the charge-discharge data; and a fourth temperature variation amount calculation unit that calculates a fourth temperature variation amount, due to the heat transfer between a periphery in the battery board and the energy storage device, based on the ambient temperature. The temperature estimation unit may estimate a temperature of the energy storage device based on the third temperature variation amount and the fourth temperature variation amount.

The third temperature variation amount calculation unit may calculate the third temperature variation amount of the energy storage device, due to heat generation caused by charge-discharge, based on the charge-discharge data. The internal resistance of the energy storage device is denoted by R, and the heat capacity of the energy storage device is denoted by C. When the current of the energy storage device is denoted by i, the calorific value Q of the energy storage device can be simply expressed by $Q = i^2 \cdot R$, and the third temperature variation amount of the energy storage device can be calculated using an equation as (Q/C).

The fourth temperature variation amount calculation unit may calculate the fourth temperature variation amount, due to heat transfer between the periphery in the battery board and the energy storage device, based on the ambient temperature. The ambient temperature inside the battery board is defined as Ta, and the temperature of the energy storage device is defined as T. The fourth temperature variation amount of the energy storage device can be calculated using an equation (T - Ta). The influence of the heat retention due to warming of the air in the battery board can be considered using the ambient temperature Ta.

The temperature estimation unit may estimate the temperature of the energy storage device based on the third temperature variation amount and the fourth temperature variation amount. Thus, the temperature of the energy storage device can be calculated in consideration of not only the temperature variation amount due to the heat generation of the energy storage device but also the influence of heat retention due to the warming of the air in the battery board, so that the temperature of the energy storage device incorporated in the battery board can be accurately estimated.

The temperature estimation device may include a full charge capacity estimation unit that estimates a full charge capacity of the energy storage device based on the temperature of the energy storage device estimated by the temperature estimation unit.

The full charge capacity estimation unit may estimate the full charge capacity of the energy storage device based on the temperature of the energy storage device estimated by the temperature estimation unit. The full charge capacity is a capacity when the energy storage device is fully charged. When the manufacturing time point of the energy storage device is denoted by 100%, the full charge capacity tends to gradually decrease due to aging. In addition, a decrease degree of the full charge capacity tends to increase as the temperature of the energy storage device increases. When the temperature of the energy storage device can be accurately estimated, the full charge capacity of the energy storage device can also be accurately estimated.

## ADVANTAGES OF THE INVENTION

According to the present invention, the temperature of the energy storage device incorporated in the battery board can be accurately estimated.

## BRIEF DESCRIPTION OF THE DRAWINGS

Fig. 1 is a view illustrating an example of a configuration of a temperature estimation device.
Fig. 2 is a view illustrating an example of a structure of a battery board.
Fig. 3 is a view illustrating an example of operation data.
Fig. 4 is a view illustrating an example of an arithmetic operation by a mathematical model.
Fig. 5 is a view illustrating an example of the arithmetic operation by a temperature estimation model.
Fig. 6 is a schematic diagram illustrating a concept of cell temperature estimation by the temperature estimation device.
Fig. 7 is a view illustrating an example of a temporal change in a full charge capacity of a cell.
Fig. 8 is a flowchart illustrating an example of a procedure for setting a parameter of an ambient temperature estimation model.
Fig. 9 is a flowchart illustrating an example of a procedure for estimating a cell temperature by the temperature estimation device.
Fig. 10 is a view illustrating an evaluation example of an estimated value of the cell temperature when a load is small.
Fig. 11 is a view illustrating an evaluation example of the estimated value of the cell temperature when the load is moderate.
Fig. 12 is a view illustrating an evaluation example of the estimated value of the cell temperature when the load is large.
Fig. 13 is a view illustrating an evaluation example of the estimated value of the cell temperature in a case of a capacity checking test.
Fig. 14 is a view illustrating a first example of the evaluation example of the estimated value of the cell temperature in the case of a comparative example.
Fig. 15 is a view illustrating a second example of the evaluation example of the estimated value of the cell temperature in the case of the comparative example.

MODE FOR CARRYING OUT THE INVENTION

Hereinafter, a temperature estimation device according to an embodiment will be described with reference to the drawings. Fig. 1 is a view illustrating an example of a configuration of a temperature estimation device 50. The temperature estimation device 50 includes a controller 51 that controls an entire device, an input unit 52, a storage 53, a model execution unit 54, a capacity estimation unit 55, an output unit 56, and a model update unit 57. The controller 51 includes a central processing unit (CPU), a read only memory (ROM), and a random access memory (RAM).

The input unit 52 can acquire required information from an external server or device through wireless communication or wired communication. For example, the input unit 52 can acquire operation data of a power storage system. For example, the energy storage system is used in a thermal power generating system, a mega solar power generating system, a wind power generating system, an uninterruptible power supply (UPS), and a railway stabilized power supply system. The power storage system includes one or a plurality of battery boards (also referred to as banks).

Fig. 2 is a view illustrating an example of a structure of a battery board 30. A plurality of (three in the example of Fig. 2) modules 20 are disposed inside the battery board 30. In each module 20, a plurality of (8 in the example of Fig. 2) cells (also referred to as energy storage devices) 10 are connected in series. The cells 10 in the module 20 are not limited to those connected in series, but may be connected in parallel or a combination of series and parallel. In the present specification, a temperature of a surface S1 of the cell 10 is represented by a cell temperature T, a temperature of a required place S2 of a cell ambient layer in the battery board 30 around the cell 10 is represented by an ambient temperature Ta, and a temperature of a required place S3 of an environmental temperature layer outside the battery board 30 is represented by an environmental temperature Tb. For example, the place S3 is a place where a temperature sensor is installed. The environmental temperature Tb is a temperature outside the battery board 30, for example, a temperature of a room in which the battery board 30 is installed, and can be a set temperature set to a required temperature depending on an operation state of the power storage system. In the present specification, the energy storage device is preferably a rechargeable device such as a secondary battery such as a lead-acid battery and a lithium ion battery or a capacitor. Apart of the energy storage device may be a non-rechargeable primary battery.

The operation data may include data actually obtained not only during the operation of the energy storage system but also at a trial run before the operation of the energy storage system, a final stage of design, or the like. The operation data includes time series data such as a set temperature of the power storage system and a load pattern for the power storage system.

Fig. 3 is a view illustrating an example of the operation data. Fig. 3A illustrates an example of environmental temperature data. In Fig. 3A, a vertical axis indicates temperature, and a horizontal axis indicates time. The environmental temperature data is time-series temperature data managing the temperature at which the power storage system is installed so as to set and maintain the temperature at a required temperature. The environmental temperature data can be time-series data of an operation period from an operation start to an operation end of the power storage system, and the operation period can be an appropriate period such as one day, one week, two weeks, one month, three months, half a year, one year, or the like depending on the operation state of the power storage system. In the example of Fig. 3, one day is illustrated in a time unit from 0:00 to 24:00.

Fig. 3B illustrates an example of the load pattern. In Fig. 3B, the vertical axis indicates voltage, and the horizontal axis indicates time. The load pattern is also referred to as a power pattern, is power data input to the power storage system, and can be positive power data during charge of the power storage system and be negative power data during discharge of the power storage system. The load pattern may be time-series data of the operation period from the operation start to the operation end of the power storage system, and the operation period may be an appropriate period such as one day, one week, two weeks, one month, three months, half a year, one year, or the like depending on the operation state of the power storage system. In the example of Fig. 3, one day is illustrated in a time unit from 0:00 to 24:00.

The storage 53 is configured of a semiconductor memory, a hard disk, or the like, and can hold the operation data acquired by the input unit 52. In addition, the storage 53 holds a mathematical model 61 and a temperature estimation model 62. For example, each of the mathematical model 61 and the temperature estimation model 62 is an execution code executed by a programming language or numerical analysis software, and specifically, the model execution unit 54 provides an execution environment of each of the mathematical model 61 and the temperature estimation model 62.

The model execution unit 54 can include a CPU, a ROM, and a RAM, or may include a graphics processing unit (GPU). The model execution unit 54 executes processing for inputting input data to the mathematical model 61 and outputting output data from the mathematical model 61. In addition, the model execution unit 54 executes processing for inputting input data to the temperature estimation model 62 and outputting output data from the temperature estimation model 62.

Fig. 4 is a view illustrating an example of an arithmetic operation by the mathematical model 61. As illustrated in Fig. 4, when the load pattern (time-series data of power) is input to the mathematical model 61, the mathematical model 61 outputs charge-discharge data (current pattern). The charge-discharge data can be time-series data of a charge current or a discharge current of the power storage system (more specifically, each cell). The mathematical model 61 is a model in which a characteristic of the cell is mathematically described using an algebraic equation, a differential equation, and a characteristic parameter, and is obtained by executing simulation. When the charge-discharge data of the power storage system can be directly acquired from an external server or device through the input unit 52, the mathematical model 61 is not required to be included.

Fig. 5 is a view illustrating an example of the arithmetic operation by the temperature estimation model 62. The temperature estimation model 62 includes an ambient temperature estimation model 621 and a cell temperature estimation model 622. When the environmental temperature data (represented by Tb) and the charge-discharge data of the power storage system are input to the ambient temperature estimation model 621, the ambient temperature estimation model 621 outputs the ambient temperature Ta. When the charge-discharge data of the power storage system and the ambient temperature Ta output by the ambient temperature estimation model 621 are input to the cell temperature estimation model 622, the cell temperature estimation model 622 outputs a cell temperature T (the time-series data of the estimated value of the cell temperature). The ambient temperature estimation model 621 and the cell temperature estimation model 622 are executed in synchronization with sampling timing of the time-series data. Details of the ambient temperature estimation model 621 and the cell temperature estimation model 622 will be described below.

The ambient temperature estimation model 621 can update the ambient temperature using the following arithmetic expression (1).

$$Ta' = Ta + a\cdot(Q/C)^{p} + b\cdot(Ta - Tb)^{q} \quad \cdots\cdots \quad (1)$$

Where, Ta is the ambient temperature before the update, and Ta' is the ambient temperature after the update. Q represents a calorific value of the cell 10, C represents heat capacity of the cell 10, and Tb represents the environmental temperature. a is a first coefficient, p is a first exponent, and a and p are collectively referred to as a heat retention parameter. b is a second coefficient, q is a second exponent, and b and q are collectively referred to as a heat transfer parameter of the cell ambient layer and the environmental temperature layer. The heat retention parameter and the heat transfer parameter are collectively referred to simply as a parameter.

The heat retention in the battery board 30 affects the accuracy of the temperature of the cell 10 while the cell 10 is accommodated in the battery board 30. Accordingly, the temperature in the battery board 30 (the temperature in the heat retention state) is defined as the ambient temperature Ta. The ambient temperature Ta depends on heat generation of the cell 10, and a calorific value Q of the cell 10 depends on the charge-discharge data of the cell 10. The ambient temperature Ta depends on heat transfer between the inside and the outside of the battery board 30, and the heat transfer depends on the environmental temperature data Tb outside the battery board 30. Accordingly, the ambient temperature Ta can be calculated using the charge-discharge data and the environmental temperature data Tb.

When a second term of the arithmetic expression (1) is denoted by a first temperature variation amount, the first temperature variation amount represents a temperature variation amount in the battery board 30 due to the heat generation of the cell 10 caused by the charge-discharge. When an internal resistance of the cell 10 is denoted by R, when the heat capacity of the cell 10 is denoted by C, and when the current of the cell 10 is denoted by i, the calorific value Q of the cell 10 can be simply expressed by $Q = i^2 \cdot R$, and the first temperature variation amount given to the ambient temperature in the battery board 30 can be calculated using an equation converted into the temperature as in (Q/C). The calorific value Q of the cell 10 may be simply represented by $i^2 \cdot R$, and a term of a linear expression of the current i may be further added.

More specifically, as in the second term of the arithmetic expression (1), the first temperature variation amount may be calculated using an expression $(Q/C)^p$ that powers the value (Q/C) obtained by dividing the calorific value Q of the cell 10 by the heat capacity C of the cell 10 by the first exponent p. Furthermore, the first temperature variation amount may be calculated by multiplying the expression $(Q/C)^p$ by a first coefficient a. The heat retention parameters a, p can be real numbers. However, the heat retention parameters a, p can vary depending on design conditions such as capacity and structure of the power storage system, so that an appropriate value may be selected depending on the power storage system. Thus, the first temperature variation amount can be calculated regardless of the structure of the power storage system or the like.

When a third term of the arithmetic expression (1) is denoted by a second temperature variation amount, the second temperature variation amount represents a temperature variation amount in the battery board 30 due to the heat transfer between the environment outside the battery board 30 and the inside of the battery board 30. The environmental temperature outside the battery board 30 is denoted by Tb, and the ambient temperature inside the battery board is denoted by Ta. The second temperature variation amount given to the ambient temperature in the battery board 30 can be calculated using an expression as (Ta - Tb).

More specifically, as in the third term of the arithmetic expression (1), the second temperature variation amount may be calculated using an expression $(Ta - Tb)^q$ that powers the difference (Ta - Tb) between the ambient temperature Ta of the cell 10 and the environmental temperature Tb of the battery board 30 by a second exponent q. Furthermore, the second temperature variation amount may be calculated by multiplying the expression $(Ta - Tb)^q$ by a second coefficient b. The heat transfer parameters b, q can be real numbers. However, the heat transfer parameters b, q can vary depending on design conditions such as the capacity and structure of the power storage system, so that an appropriate value may be selected depending on the power storage system. Thus, the second temperature variation amount can be calculated regardless of the structure of the power storage system or the like.

As in the arithmetic expression (1), the ambient temperature Ta of the cell ambient layer of the cell 10 in the battery board 30 can be calculated based on the first temperature variation amount and the second temperature variation amount. Thus, the ambient temperature can be calculated in consideration of both the influence of the heat retention due to air in the battery board 30, the air being heated by the heat generation of the cell 10, and the influence of the heat transfer between the inside and the outside of the battery board 30.

The cell temperature estimation model 622 can update the cell temperature using arithmetic expression (2).

$$T' = T + (Q/C) + h \cdot (T - Ta) \quad \cdots\cdots (2)$$

Where, T is the cell temperature before the update, T' is the cell temperature after the update, Q indicates the calorific value of the cell 10, C indicates the heat capacity of the cell 10, and Ta is the ambient temperature updated by the ambient temperature estimation model 621. h is a heat transfer parameter (also simply referred to as a "parameter") of a cell-cell ambient layer.

When the second term of the arithmetic expression (2) is denoted by a third temperature variation amount, the third temperature variation amount represents a variation amount of the cell temperature of the cell 10 due to the heat generation caused by the charge-discharge. When the internal resistance of the cell 10 is denoted by R, when the heat capacity of the cell 10 is denoted by C, and when the current of the cell 10 is denoted by i, the calorific value Q of the cell 10 can be simply expressed by $Q = i^2 \cdot R$, and the third temperature variation amount representing the cell temperature can be calculated using the expression as (Q/C). The calorific value Q of the cell 10 may be simply represented by $i^2 \cdot R$, and a term of the linear expression of the current i may be further added.

When the third term of the arithmetic expression (2) is denoted by a fourth temperature variation amount, the fourth temperature variation amount represents a temperature variation amount due to the heat transfer between the periphery in the battery board 30 and the cell 10. The ambient temperature inside the battery board 30 is defined as Ta, and the temperature of the cell 10 is defined as T. The fourth temperature variation amount can be calculated using an expression such as h (T - Ta). The influence of the heat retention due to warming of the air in the battery board 30 can be considered using the ambient temperature Ta.

Because the temperature (for example, the surface temperature of the cell 10 and the like) of the cell 10 depends on the calorific value of the cell 10, the temperature of the cell 10 depends on the charge-discharge data of the cell 10. In addition, the temperature of the cell 10 depends on the heat transfer with the periphery of the cell 10, and the heat transfer depends on the ambient temperature Ta. Accordingly, the temperature of the cell 10 can be calculated using the ambient temperature Ta and the charge-discharge data.

Like the arithmetic expression (2), the temperature of the cell 10 can be estimated based on the third temperature variation amount and the fourth temperature variation amount. Thus, since the temperature of the cell 10 can be calculated in consideration of not only the temperature variation amount due to the heat generation of the cell 10 but also the influence of the heat retention (that is, the ambient temperature Ta that is the temperature inside the battery board 30) caused by the heated air in the battery board 30, the influence of the heat retention inside the battery board 30 can be mimicked, and the temperature of the cell incorporated in the battery board 30 can be accurately estimated.

The capacity estimation unit 55 can estimate the full charge capacity of the cell 10 (or the power storage system) based on the temperature of the cell 10 (or the power storage system) estimated by the temperature estimation model 62. The full charge capacity is a capacity when the cell 10 is fully charged.

The output unit 56 can output data of the cell temperature estimated by the temperature estimation model 62 to the external device. In addition, the output unit 56 can output the full charge capacity estimated by the capacity estimation unit 55 to the external device.

Fig. 6 is a schematic diagram illustrating a concept of cell temperature estimation by the temperature estimation device. As illustrated in Fig. 6A, in the embodiment, the cell ambient layer (Ta) is defined between the cell and the environmental temperature layer (Tb). By defining the cell ambient layer (Ta), the heat transfer between the cell ambient layer (Ta) and the environmental temperature layer (Tb) is considered while the heat transfer between the cell and the cell ambient layer (Ta) is considered. The heat transfer between the cell ambient layer (Ta) and the environmental temperature layer (Tb) can be formulated by the arithmetic expression (1) described above. In addition, the heat transfer between the cell and the cell ambient layer (Ta) can be formulated by the arithmetic expression (2) described above.

Fig. 6B schematically illustrates a relationship among the load pattern, the environmental temperature Tb, the cell ambient temperature Ta, and the cell temperature T. That is, the cell ambient temperature Ta can be obtained from a measured value of the load pattern and a measured value of the environmental temperature Tb. In this case, as illustrated in Fig. 4, the load pattern is converted into a charge-discharge pattern, and the converted charge-discharge pattern is used. As illustrated in Fig. 5, the cell temperature T can be obtained from the load pattern and the cell ambient temperature Ta. In this case, as illustrated in Fig. 4, the load pattern is converted into the charge-discharge pattern, and the converted charge-discharge pattern is used. In addition, the capacity can be estimated from the cell temperature T.

Fig. 7 is a view illustrating an example of a temporal change in the full charge capacity of the cell 10. In Fig. 7, the vertical axis indicates the full charge capacity, and the horizontal axis indicates time. When the manufacturing time point of the cell 10 is denoted by 100%, the full charge capacity tends to gradually decrease due to aging. In addition, a decrease degree of the full charge capacity tends to increase as the temperature of the cell 10 increases. In Fig. 7, a curve indicated by a sign A represents the transition of the full charge capacity when the temperature of the cell 10 (referred to as the temperature of the cell alone) is T0. However, in the actual power storage system, each of the cells 10 is accommodated in the battery board 30, and as described above, due to the influence of the heat retention in the battery board 30, the temperature of the cell 10 tends to be higher than that the case of the cell alone. In addition, there is some possibility that the temperature of the cell 10 varies depending on the battery board 30 even when the battery board 30 is operated under the same environment and load condition depending on the design condition and structure of the battery board. As illustrated in Fig. 7, curves indicated by signs B to D represent transitions of the full charge capacity when the temperatures of the cells 10 in the different battery boards 30 are T1, T2, T3. As described above, for example, assuming that the temperature of the cell 10 estimated by the temperature estimation model 62 is T1, the transition of the full charge capacity is represented by the curve indicated by the sign B. When the temperature of the cell 10 can be accurately estimated, a curve of the full charge capacity can be accurately estimated.

The transition of the full charge capacity as exemplified in Fig. 7 can be obtained by a required simulator. For example, when the SOC time-series data and the temperature time-series data of the power storage system are input to the simulator, the simulator can output the full charge capacity time-series data. That is, when the time-series data of the SOC and the time-series data of the temperature of the power storage system are input, the capacity estimation unit 55 can estimate the full charge capacity of the power storage system by correcting (or providing) the time-series temperature data input to the simulator that outputs the time-series data of the full charge capacity. The capacity estimation unit 55 may include the simulator.

The parameters a, p, b, q in the arithmetic expression (1) of the ambient temperature estimation model 621 can be appropriately set according to the power storage system. A parameter setting method will be described below.

Fig. 8 is a flowchart illustrating an example of a procedure for setting the parameters of the ambient temperature estimation model 621. The parameters can be set before the operation of the power storage system is started. The set parameters can be updated during the operation of the power storage system to improve the estimation accuracy of the cell temperature. Apart of the operation data assumed before starting the operation is selected to actually operate the power storage system, the measured value of the temperature of the cell 10 in the battery board 30 is acquired, and the parameter is set using the acquired measured value. Hereinafter, a specific description will be given. A subject of the processing is the controller 51 for convenience, but the parameter may be set by a device other than the temperature estimation device 50.

The controller 51 acquires the measured values of the cell temperature (the temperature of the cell 10 in the battery board 30) when the power storage system is actually operated (worked) and the environmental temperature outside the battery board 30 based on the operation data of the power storage system (S11). The work period may be an appropriate period such as one day, one week, or two weeks. In the battery board 30, the measured value of the temperature of the cell 10 or the cell group having the highest temperature among the cells 10 in the battery board 30 may be acquired when the temperature difference of each cell 10 is relatively large according to the position of the cell 10.

The controller 51 acquires the load pattern and the environmental temperature data that are included in the operation data when the power storage system is actually worked (S12). The controller 51 inputs the load pattern to the mathematical model 61 for the power storage system and calculates the charge-discharge data during the work of the power storage system (S13). Thus, the measured value and the calculated value that are required for setting the parameter can be obtained.

The controller 51 sets the parameters a, p, b, q of the ambient temperature estimation model 621 to initial values, and sets the parameter h of the cell temperature estimation model 622 to the initial value (S14). When the parameter h is previously determined, a predetermined value may be set as the initial value. Hereinafter, it is assumed that the parameter h is already set to a predetermined value.

The controller 51 sets the cell temperature T and the ambient temperature Ta to the initial value (environmental temperature Tb) (S15). The controller 51 updates the ambient temperature using the charge-discharge data, the environmental temperature data, and the ambient temperature estimation model 621 (S16), and updates the cell temperature using the updated ambient temperature, the charge-discharge data, and the cell temperature estimation model 622 (S17).

The controller 51 determines whether a difference between the updated cell temperature and the measured value of the cell temperature is within an allowable range (S18). For example, the difference from the measured value of the cell temperature can be calculated using a least squares method.

When the difference between the updated cell temperature and the measured value of the cell temperature is not within the allowable range (NO in S18), the parameter is set (S19), and the pieces of processing after step S15 are continued. At this point, the parameters are set by changing the parameters a, p, b, q of the ambient temperature estimation model 621. In this way, the parameters a, p, b, q of the ambient temperature estimation model 621 are changed such that the difference between the updated cell temperature and the measured value of the cell temperature falls within the allowable range.

When the difference between the updated cell temperature and the measured value of the cell temperature is within the allowable range (YES in S18), the controller 51 generates the ambient temperature estimation model 621 and the cell temperature estimation model 622 using the set parameters (S20), and ends the processing.

A temperature estimation method by the temperature estimation device 50 will be described below. According to the temperature estimation device 50, the cell temperature of the power storage system can be accurately estimated based on the operation data even when the power storage system is not actually worked before the operation of the power storage system is started. A method for estimating the cell temperature will be described below.

Fig. 9 is a flowchart illustrating an example of a procedure for estimating the cell temperature by the temperature estimation device 50. The controller 51 acquires the load pattern and the environmental temperature data that are included in the operation data of the power storage system (S31). The controller 51 inputs the load pattern to the mathematical model 61 for the power storage system and calculates the charge-discharge data (S32). When the charge-discharge data of the power storage system can be directly acquired, the processing of step S32 is not required.

The controller 51 inputs the charge-discharge data and the environmental temperature data to the ambient temperature estimation model 621 to update the ambient temperature (S33), and inputs the charge-discharge data and the updated ambient temperature to the cell temperature estimation model 622 to update the cell temperature (S34).

The controller 51 determines whether the update of the cell temperature is completed (S35). That is, the controller 51 determines whether all the charge-discharge data and the environmental temperature data are input to the ambient temperature estimation model 621 and the cell temperature estimation model 622.

When the update of the cell temperature is not completed (NO in S35), the controller 51 continues the pieces of processing after step S33. When the update of the cell temperature is completed (YES in S35), the controller 51 outputs the estimated value of the cell temperature (S36), estimates the full charge capacity based on the estimated cell temperature (S37), and ends the processing.

The temperature estimation device 50 can also be implemented using a general-purpose computer including a CPU (processor), a GPU, and a RAM (memory). That is, a computer program defining a procedure of each processing as illustrated in Figs. 8 and 9 is loaded into the RAM (memory) included in the computer, and the computer program is executed by the CPU (processor), so that the computer program can be implemented on the computer. The computer program may be recorded on a recording medium and distributed.

As described above, according to the temperature estimation device 50, the temperature of the cell 10 accommodated in the battery board 30 can be accurately estimated before the operation of the power storage system is started. In addition, the temperature of the cell 10 can be accurately estimated, so that the full charge capacity of the power storage system can be accurately estimated. The full charge capacity of the power storage system can be accurately estimated, so that the life of the power storage system in operation can be estimated from the load assumed in the future, and the time when the life of the power storage system reaches or the time that falls below the minimum required capacity can be accurately estimated. Thus, preparation for replacement or expansion of the cells 10 (specifically, the module 20) in the power storage system can be systematically and efficiently performed. In addition, the electric characteristic (for example, the internal resistance of the cell 10 or the like) depending on the temperature of the power storage system can also be accurately estimated, so that the estimation accuracy of the acceptance performance (charge performance) and the output performance (discharge performance) with respect to the required load power of the power storage system is improved.

When a plurality of battery boards having the same or similar design conditions and structures exist, and when all or some of the parameters of the ambient temperature estimation model 621 estimating the cell temperature of each battery board are different beyond the allowable range, it is considered that there is an abnormality in each of the battery boards 30 having different parameters from the viewpoint of the heat generation and exhaust heat. Consequently, comparing the set parameters may contribute to early detection of the abnormality of the battery board 30.

The parameters a, p, b, q of the ambient temperature estimation model 621 can be updated not only before the operation of the power storage system is started but also during the operation.

The model update unit 57 can update the parameters a, p, b, q of the arithmetic expression (1) of the ambient temperature estimation model 621. Specifically, during the operation, the measured value of the temperature of the cell 10 in the battery board 30 is acquired, and the parameter is updated using the acquired measured value. Because the update procedure is similar to that in the case of Fig. 8, the description thereof will be omitted. Thus, even when a situation in which the estimation accuracy of the cell temperature by the temperature estimation model 62 decreases due to some cause is assumed in the process for operating the power storage system, the parameter is updated, so that the decrease in the estimation accuracy of the cell temperature can be prevented and the estimation accuracy can be improved.

An evaluation result of the cell temperature estimated by the temperature estimation device 50 will be described below.

Fig. 10 is a view illustrating an evaluation example of the estimated value of the cell temperature when the load is small, Fig. 11 is a view illustrating an evaluation example of the estimated value of the cell temperature when the load is medium, Fig. 12 is a view illustrating an evaluation example of the estimated value of the cell temperature when the load is large, and Fig. 13 is a view illustrating an evaluation example of the estimated value of the cell temperature in the case of a capacity checking test. In Figs. 10A, 11A, 12A, and 13A, the vertical axis represents temperature, the horizontal axis represents time, and charts of the estimated value of the cell temperature, the measured value of the cell temperature, and the environmental temperature are illustrated. In Figs. 10B, 11B, 12B, and 13B, the vertical axis represents current and state of charge (SOC), the horizontal axis represents time, and charts of the charge-discharge data and the SOC (indicated by a solid line) are illustrated. In Figs. 10, 11, 12, and 13, the parameters a, p, b, q of the ambient temperature estimation model 621 are a = 13, p = 0.5, b = 0.08, q = 2, respectively.

As illustrated in Figs. 10, 11, and 12, it can be seen that the estimated value of the cell temperature follows in the good state (the state in which the difference between the estimated value and the measured value is within an allowable range) according to the temporal variation of the measured value in all the assumed loads (that is, until the load changes from the small state to the large state). In addition, as illustrated in Fig. 13, although it is not the actual load pattern, it can be seen that the estimated value of the cell temperature follows in the good state according to the temporal variation of the measured value also in the capacity checking test (the test in which the SOC is varied within a predetermined range). As illustrated in Figs. 10, 11, 12, and 13, it can be said that the estimated value of the cell temperature can reproduce the measured value.

In Figs. 10, 11, 12, and 13, the parameters a, p, b, q of the ambient temperature estimation model 621 are set to a = 13, p = 0.5, b = 0.08, q = 2, respectively. However, when a different power storage system is used, different parameters are set, so that the same results as those in Figs. 10, 11, 12, and 13, namely, the estimated value of the cell temperature can be followed in the good state according to the temporal variation of the measured value.

An evaluation result of the estimated value of the cell temperature in the case of the comparative example will be described below.

In the comparative example, the ambient temperature around the cell is not considered. The update formula of the cell temperature is T' = T + (Q/C) + k (T - Tb). Where, T is the cell temperature before the update, T' is the cell temperature after the update, Q indicates the calorific value of the cell, C indicates the heat capacity of the cell, and Tb indicates the environmental temperature. k is a heat transfer parameter of the cell-environmental temperature layer.

Fig. 14 is a view illustrating a first example of the evaluation example of the estimated value of the cell temperature in the case of the comparative example. Similarly to Figs. 10, 11, and 12, Figs. 14A, 14B, and 14C illustrate the case where the load is small, the case where the load is medium, and the case where the load is large, respectively. In case 2, the interval between k is smaller than that in case 1. As illustrated in Fig. 14, in case 1, it can be seen that the estimated value of the cell temperature cannot follow the variation of the measured value and the measured value cannot be reproduced in the load state in which the load ranges from small to medium. In case 2, the parameter is reduced, but it can be seen that the estimated value of the cell temperature cannot follow the variation of the measured value in the state where the load is small and large and the measured value cannot be reproduced. That is, it can be seen that the estimated value of the cell temperature cannot follow the variation of the measured value and the measured value cannot be reproduced in all the load states from small to large loads.

Fig. 15 is a view illustrating a second example of the evaluation example of the estimated value of the cell temperature in the case of the comparative example. Similarly to Figs. 10, 11, and 12, Figs. 15A, 15B, and 15C illustrate the case where the load is small, the case where the load is medium, and the case where the load is large, respectively. The second example is similar to the first example in that the ambient temperature is not considered, but the update formula of the temperature of the cell is $T' = T + (Q/C) + k\ m\ (T - Tb)^n$. In case 1, m = 1 and n = 0.5, and in case 2, m = 0.5 and n = 0.1. In both cases 1 and 2, it can be seen that the estimated value of the cell temperature cannot follow the variation of the measured value and the measured value cannot be reproduced in all load states in which the load ranges from small to large.

The embodiment is illustrative in all respects and is not restrictive. The scope of the present invention is illustrated by the scope of the claims, and includes all changes within the scope of the claims and meaning equivalent to the scope of the claims.

DESCRIPTION OF REFERENCE SIGNS

10: cell
20: module
30: battery board
50: temperature estimation device
51: controller
52: input unit
53: storage
54: model execution unit
55: capacity execution unit
56: output unit
57: model update unit
61: mathematical model
62: temperature estimation model
621: ambient temperature estimation model
622: cell temperature estimation model

## Claims

**1.** A temperature estimation device comprising:

a charge-discharge data acquisition unit that acquires charge-discharge data relating to charge-discharge of an energy storage device;
an environmental temperature data acquisition unit that acquires temperature data relating to an environmental temperature of a battery board accommodating a plurality of the energy storage devices; and
a temperature estimation unit that calculates an ambient temperature of the energy storage device in the battery board using the charge-discharge data and the temperature data, and estimates a temperature of the energy storage device using the calculated ambient temperature and the charge-discharge data.

**2.** The temperature estimation device according to claim 1, further comprising:

a first temperature variation amount calculation unit that calculates a first temperature variation amount in the battery board, due to heat generation of the energy storage device caused by the charge-discharge, based on the charge-discharge data;

a second temperature variation amount calculation unit that calculates a second temperature variation amount in the battery board, due to heat transfer between an environment outside the battery board and an inside of the battery board, based on the temperature data; and

an ambient temperature calculation unit that calculates an ambient temperature of the energy storage device in the battery board based on the first temperature variation amount and the second temperature variation amount.

**3.** The temperature estimation device according to claim 2, wherein the first temperature variation amount calculation unit calculates the first temperature variation amount using an arithmetic expression exponentiating a value, which is obtained by dividing a calorific value of the energy storage device by a heat capacity of the energy storage device, by a first exponent.

**4.** The temperature estimation device according to claim 2 or 3, wherein the second temperature variation amount calculation unit calculates the second temperature variation amount using an arithmetic expression exponentiating a difference between an ambient temperature of the energy storage device and the environmental temperature of the battery board by a second exponent.

**5.** The temperature estimation device according to any one of claims 1 to 4, further comprising:

a third temperature variation amount calculation unit that calculates a third temperature variation amount of the energy storage device, due to the heat generation caused by the charge-discharge, based on the charge-discharge data; and

a fourth temperature variation amount calculation unit that calculates a fourth temperature variation amount, due to the heat transfer between a periphery in the battery board and the energy storage device, based on the ambient temperature,

wherein the temperature estimation unit estimates a temperature of the energy storage device based on the third temperature variation amount and the fourth temperature variation amount.

**6.** The temperature estimation device according to any one of claims 1 to 5, further comprising a full charge capacity estimation unit that estimates a full charge capacity of the energy storage device based on the temperature of the energy storage device estimated by the temperature estimation unit.

**7.** A computer program causing a computer to execute:

acquiring charge-discharge data relating to charge-discharge of an energy storage device;

acquiring temperature data relating to an environmental temperature of a battery board accommodating a plurality of the energy storage devices; and

calculating an ambient temperature of the energy storage device in the battery board using the charge-discharge data and the temperature data, and estimating a temperature of the energy storage device using the calculated ambient temperature and the charge-discharge data.

**8.** A temperature estimation method comprising:

acquiring charge-discharge data relating to charge-discharge of an energy storage device;

acquiring temperature data relating to an environmental temperature of a battery board accommodating a plurality of the energy storage devices; and

calculating an ambient temperature of the energy storage device in the battery board using the charge-discharge data and the temperature data, and estimating a temperature of the energy storage device using the calculated ambient temperature and the charge-discharge data.

Fig. 1

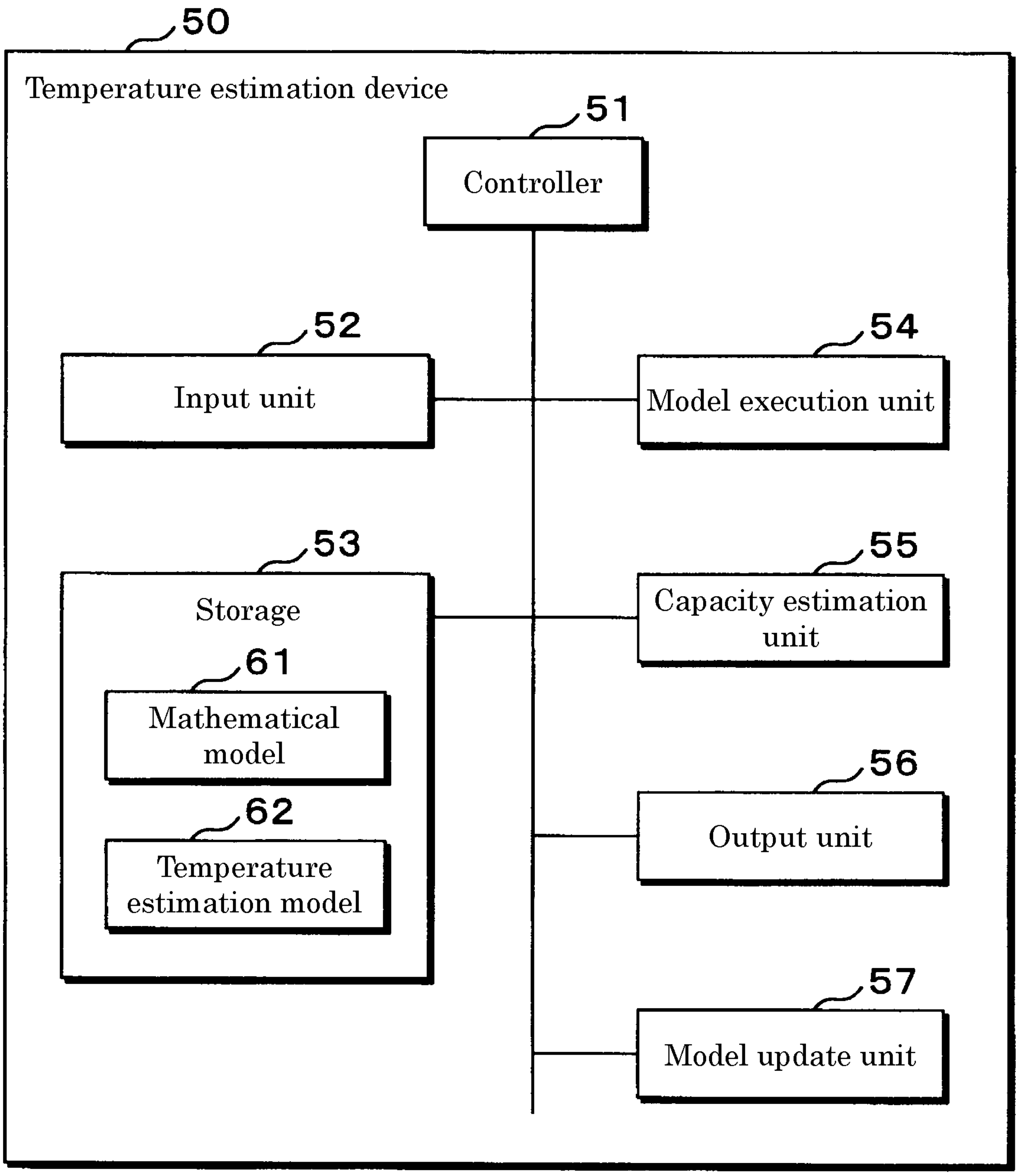
50
Temperature estimation device
51
Controller
52
Input unit
54
Model execution unit
53
Storage
55
Capacity estimation unit
61
Mathematical model
62
Temperature estimation model
56
Output unit
57
Model update unit

Fig. 2

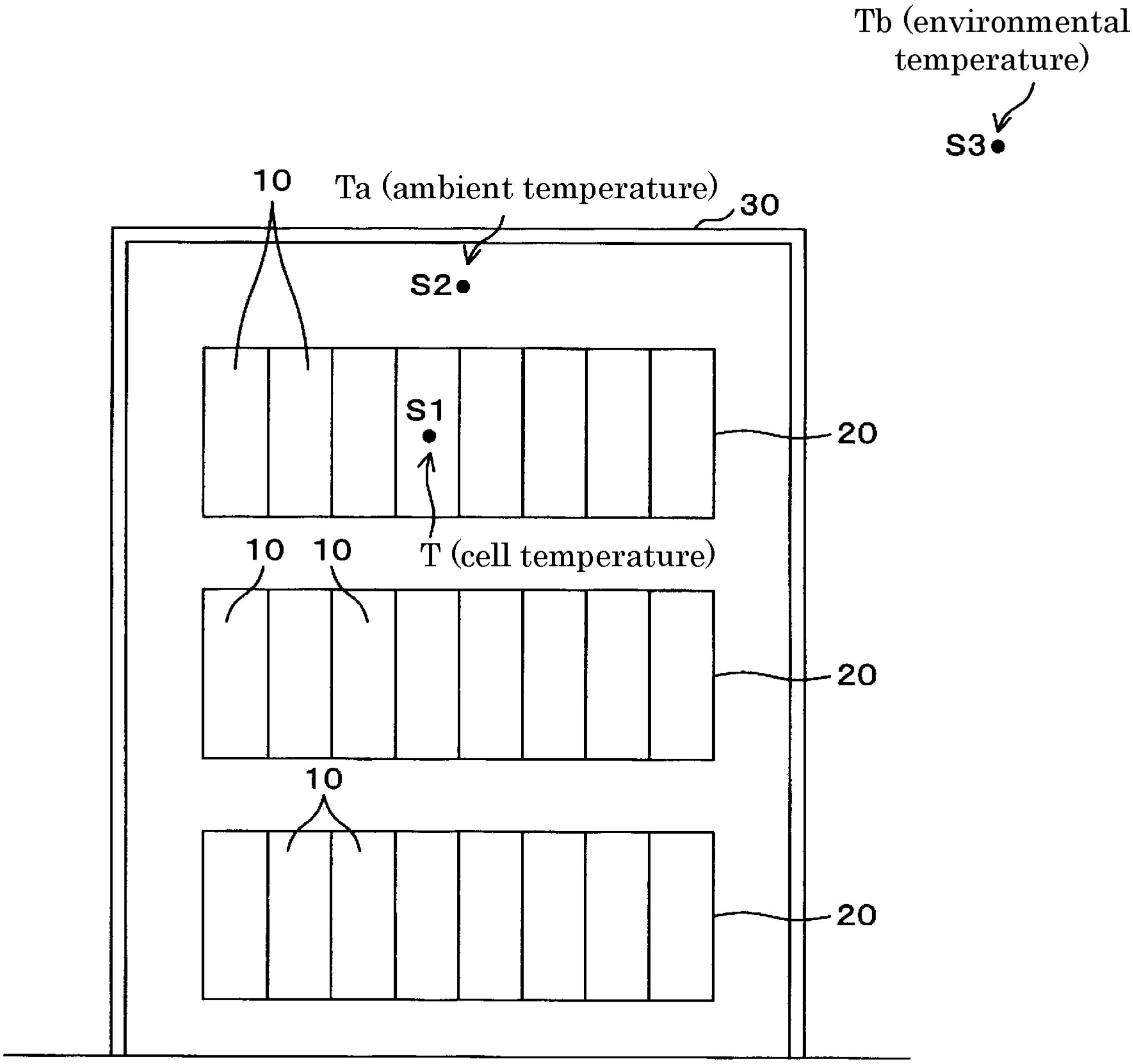

Tb (environmental temperature)
S3
10
Ta (ambient temperature)
30
S2
S1
20
10 10
T (cell temperature)
20
10
20

Fig. 3

A

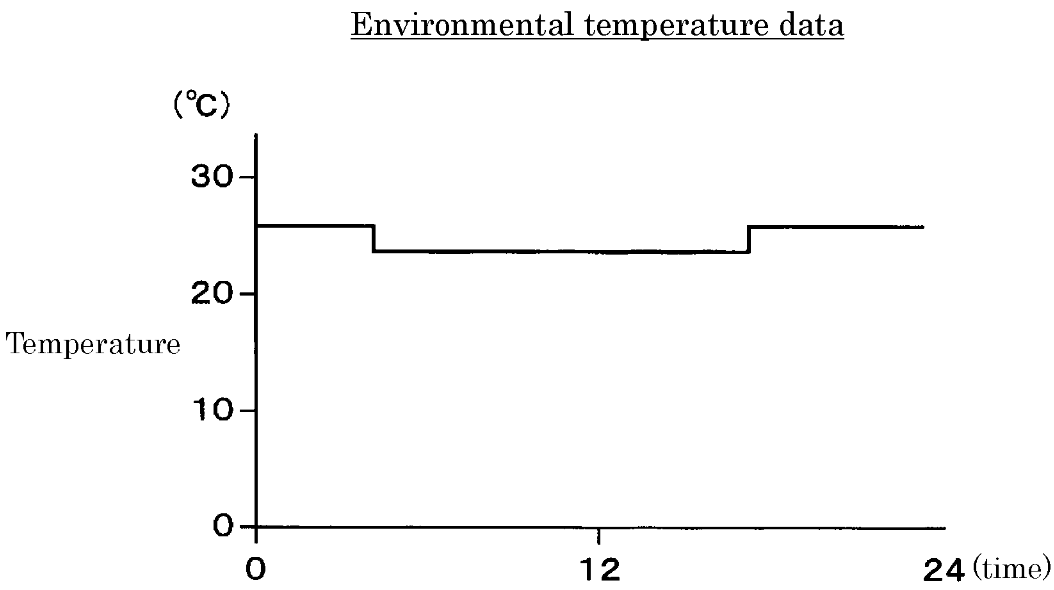

Environmental temperature data
(℃)
30
20
Temperature
10
0
0
12
24 (time)


B

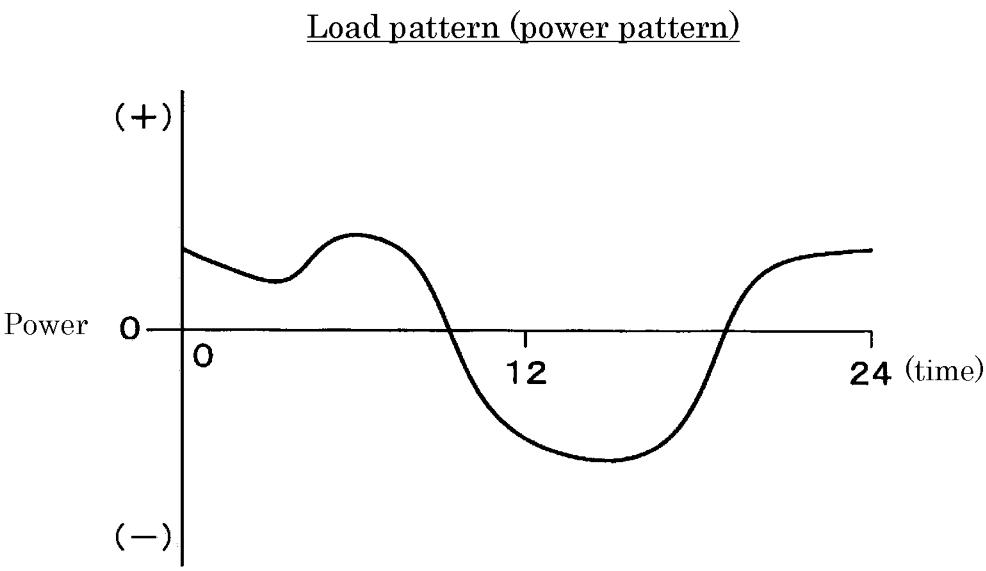

Load pattern (power pattern)
(+)
Power
0
0
12
24 (time)
(−)

Fig. 4

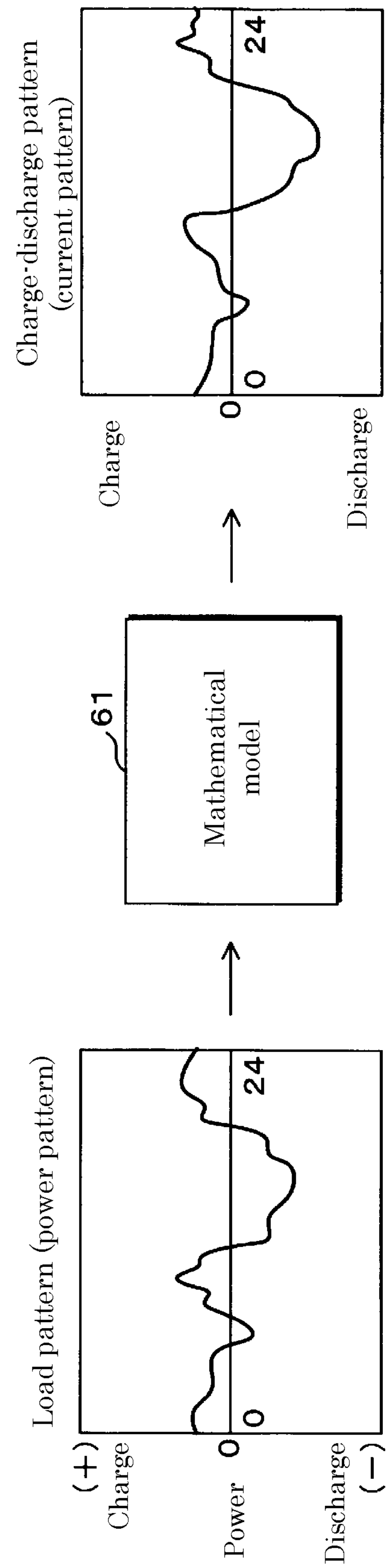
Load pattern (power pattern)
(+)
Charge
Power
0
Discharge
(−)
0
24
61
Mathematical model
Charge-discharge pattern
(current pattern)
Charge
0
Discharge
0
24

Fig. 5

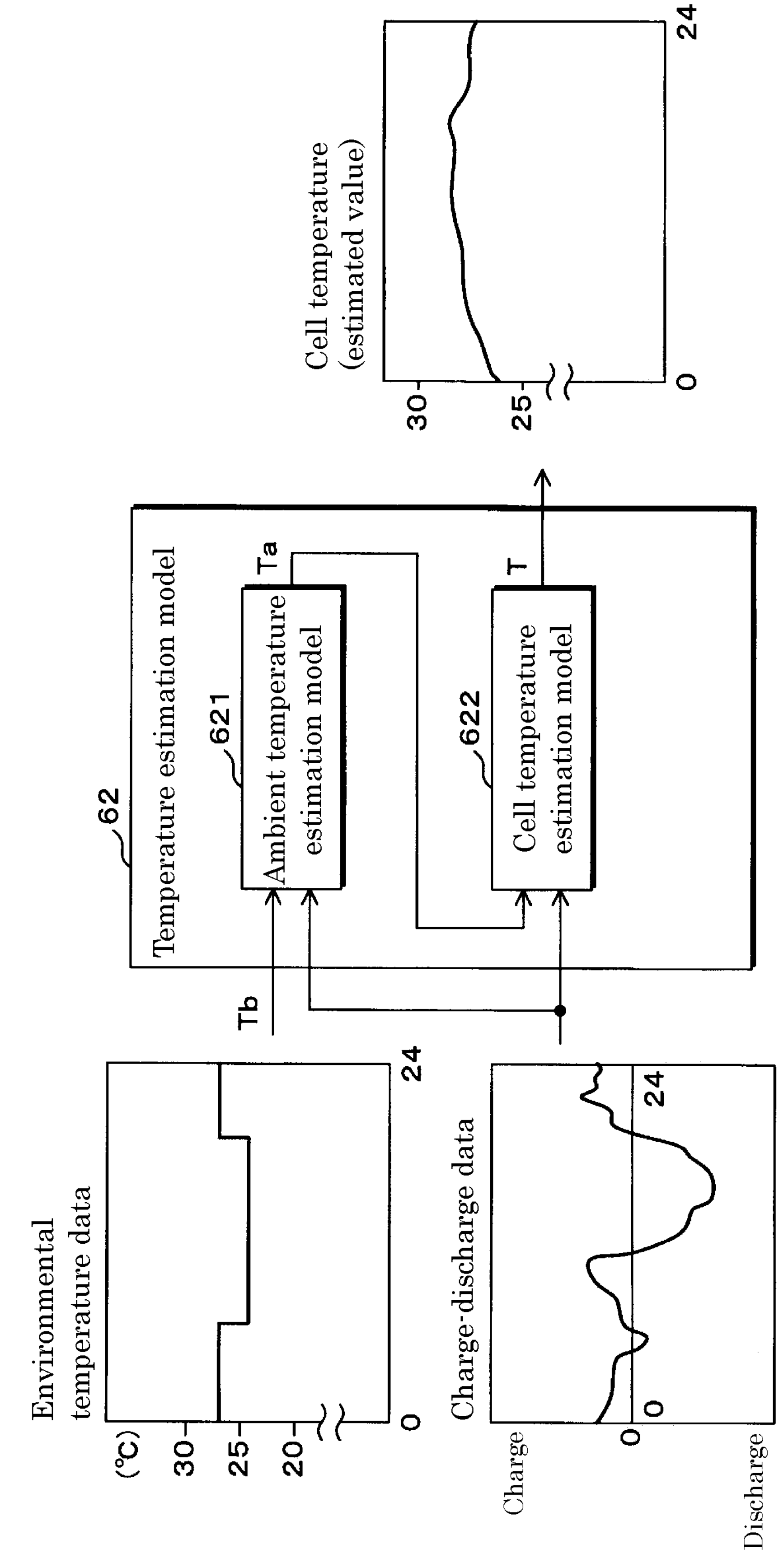
Environmental temperature data
(°C)
30
25
20
0
24
Charge-discharge data
Charge
0
Discharge
0
24
Tb
62
Temperature estimation model
621
Ambient temperature estimation model
Ta
622
Cell temperature estimation model
T
Cell temperature (estimated value)
30
25
0
24

Fig. 6

A

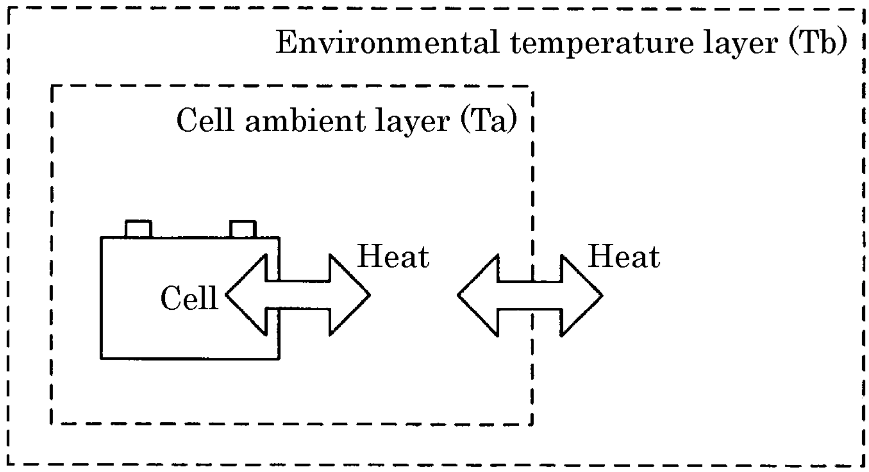
Environmental temperature layer (Tb)
Cell ambient layer (Ta)
Cell
Heat
Heat

B

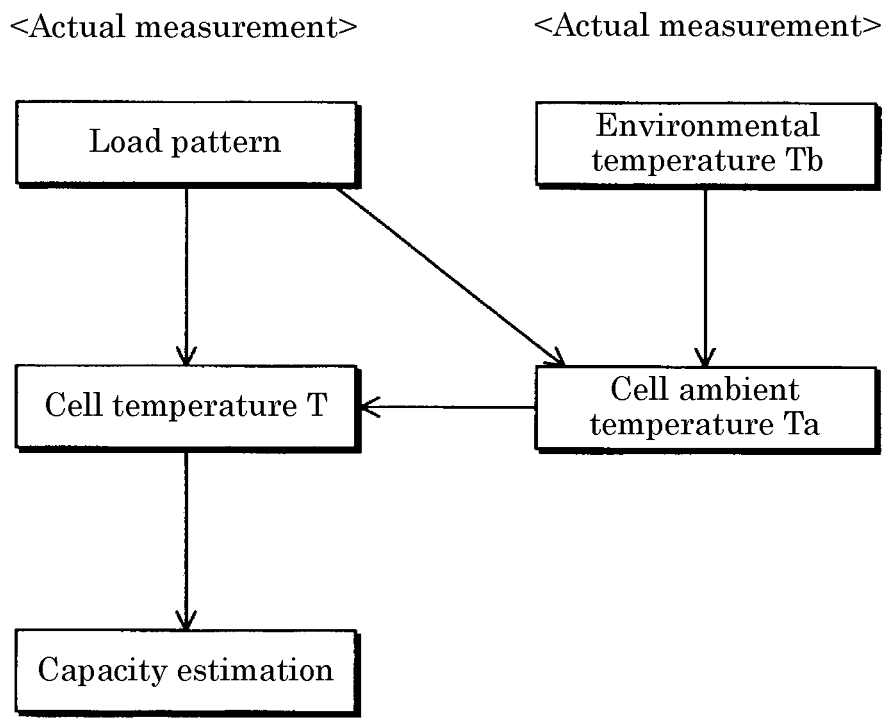
<Actual measurement>
<Actual measurement>
Load pattern
Environmental temperature Tb
Cell temperature T
Cell ambient temperature Ta
Capacity estimation

Fig. 7

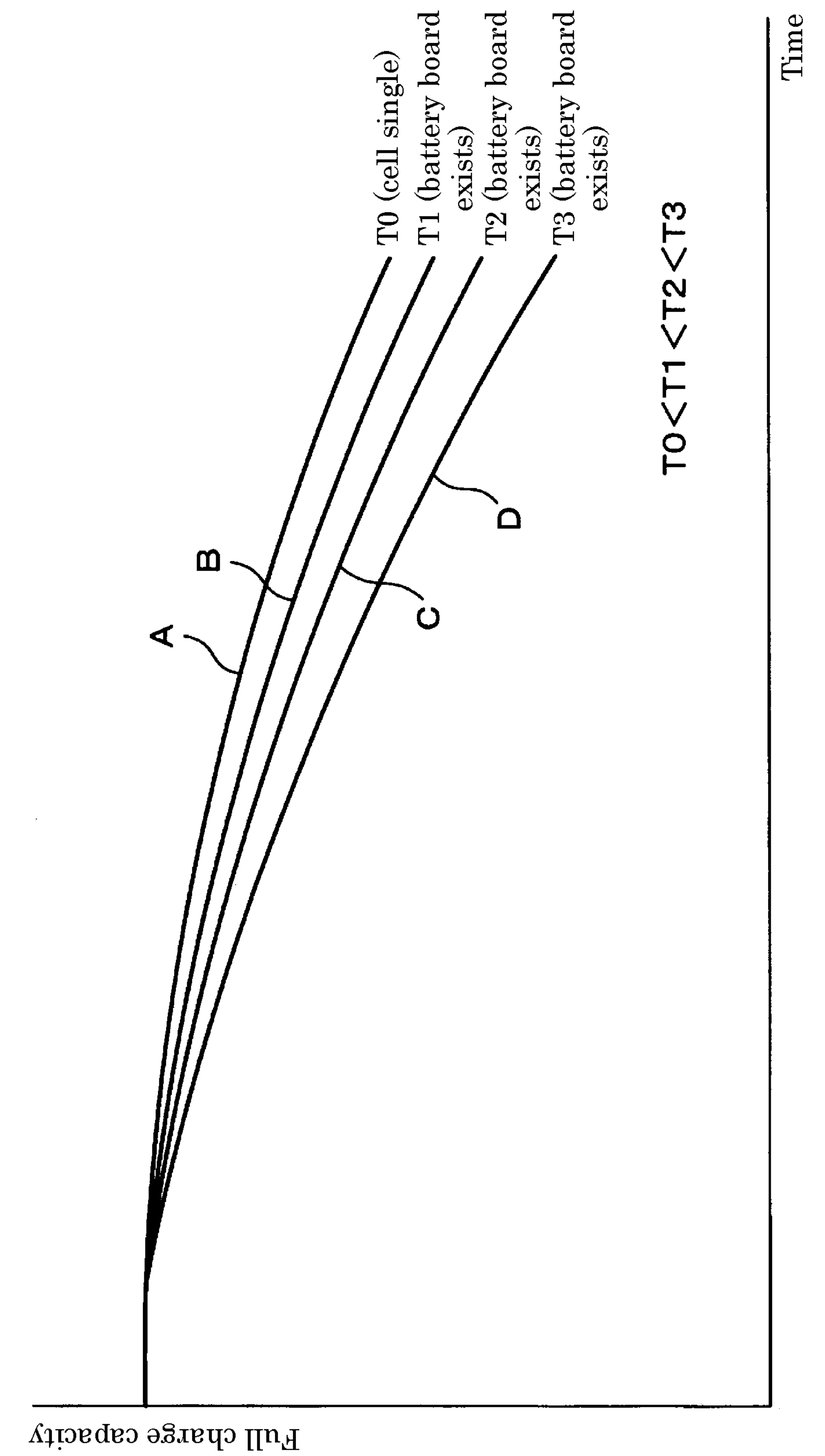
Full charge capacity
Time
T0 (cell single)
T1 (battery board exists)
T2 (battery board exists)
T3 (battery board exists)
A
B
C
D
T0<T1<T2<T3

Fig. 8

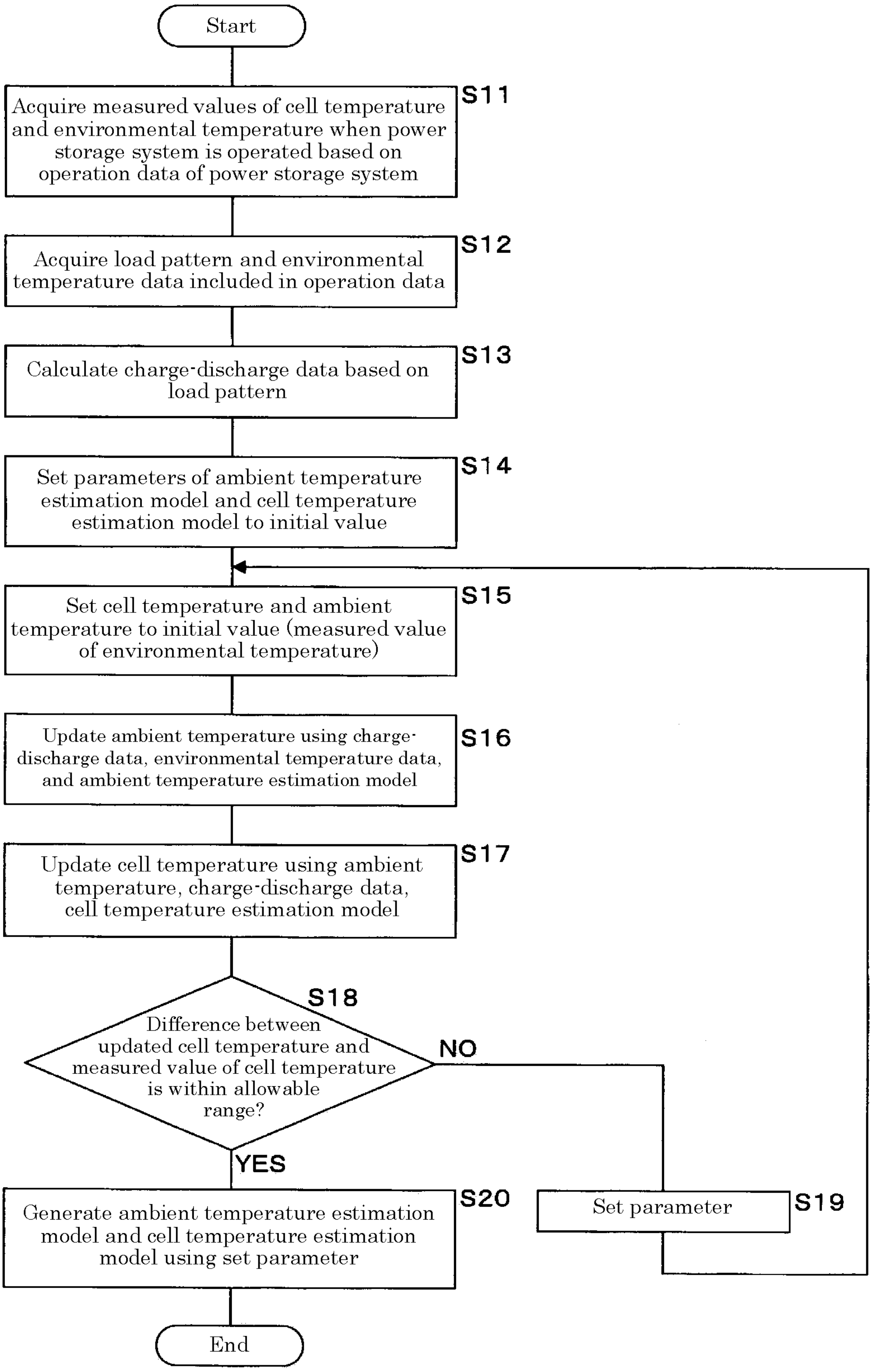
Start
Acquire measured values of cell temperature and environmental temperature when power storage system is operated based on operation data of power storage system
S11
Acquire load pattern and environmental temperature data included in operation data
S12
Calculate charge-discharge data based on load pattern
S13
Set parameters of ambient temperature estimation model and cell temperature estimation model to initial value
S14
Set cell temperature and ambient temperature to initial value (measured value of environmental temperature)
S15
Update ambient temperature using charge-discharge data, environmental temperature data, and ambient temperature estimation model
S16
Update cell temperature using ambient temperature, charge-discharge data, cell temperature estimation model
S17
S18
Difference between updated cell temperature and measured value of cell temperature is within allowable range?
NO
YES
Generate ambient temperature estimation model and cell temperature estimation model using set parameter
S20
Set parameter
S19
End

Fig. 9

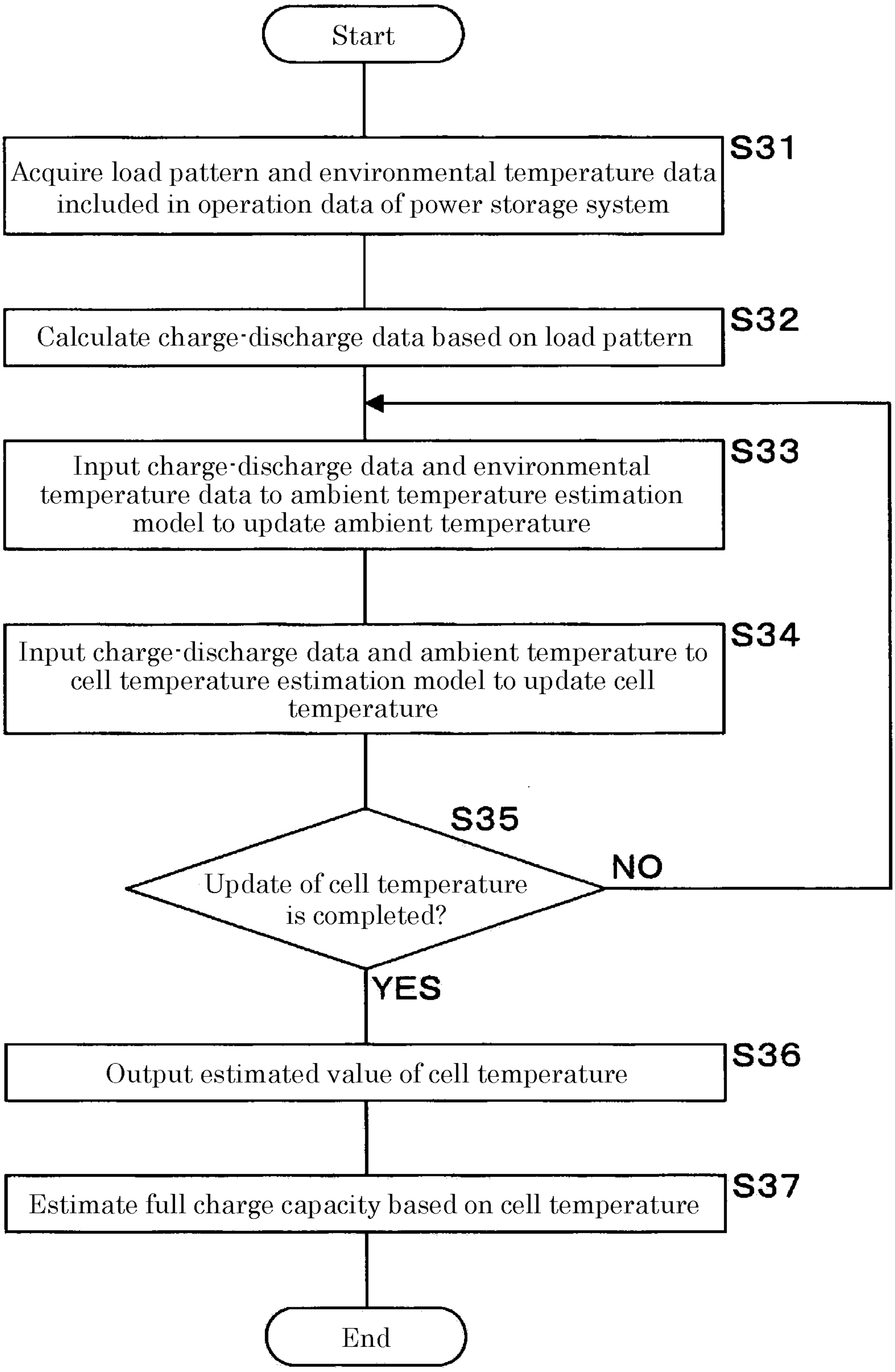
Start
Acquire load pattern and environmental temperature data included in operation data of power storage system
S31
Calculate charge-discharge data based on load pattern
S32
Input charge-discharge data and environmental temperature data to ambient temperature estimation model to update ambient temperature
S33
Input charge-discharge data and ambient temperature to cell temperature estimation model to update cell temperature
S34
S35
Update of cell temperature is completed?
NO
YES
Output estimated value of cell temperature
S36
Estimate full charge capacity based on cell temperature
S37
End

Fig. 10

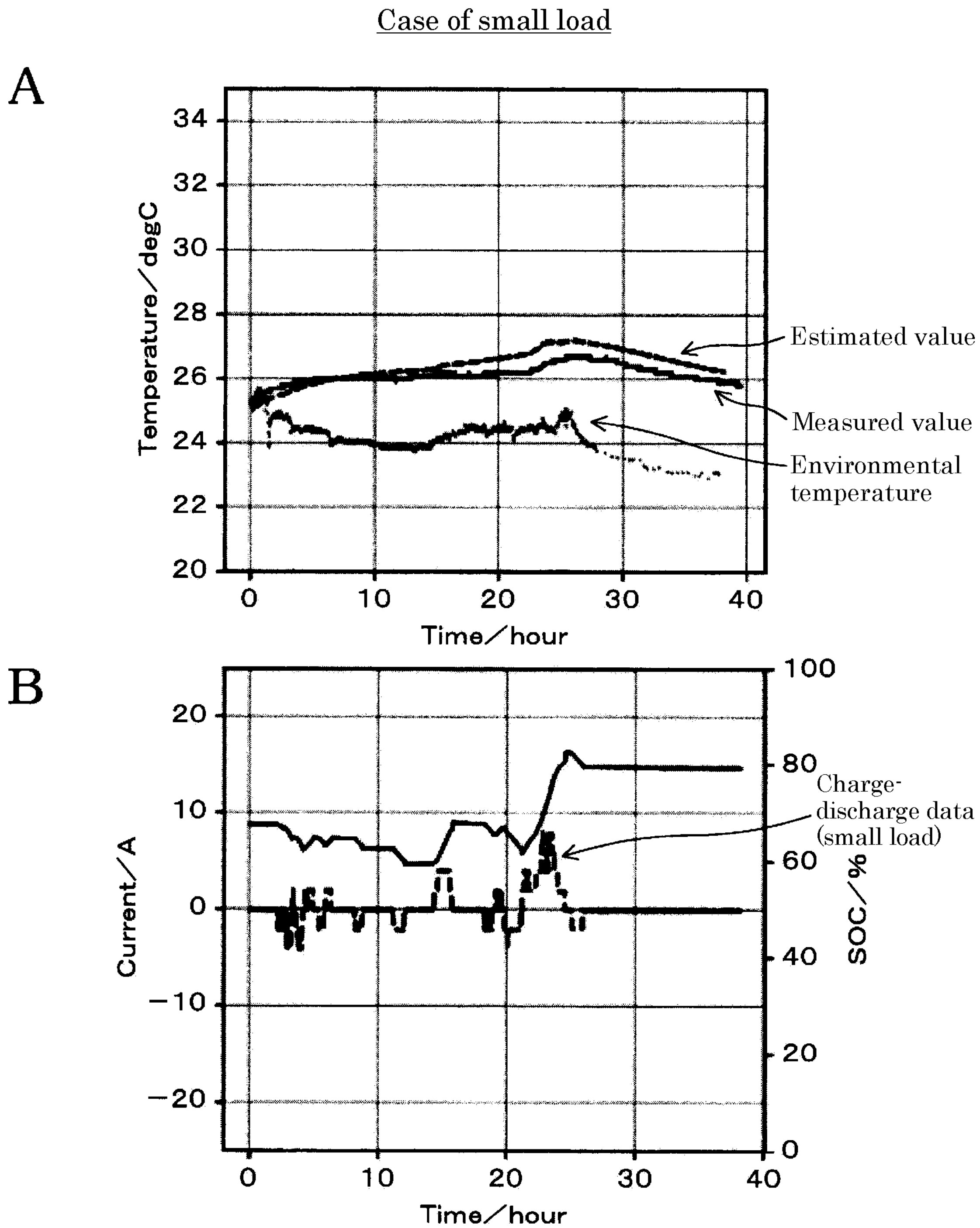
Case of small load
A
34
32
30
28
26
24
22
20
Temperature／degC
0
10
20
30
40
Time／hour
Estimated value
Measured value
Environmental temperature
B
20
10
0
−10
−20
Current／A
100
80
60
40
20
0
SOC／%
Charge-discharge data (small load)
0
10
20
30
40
Time／hour

Fig. 11

Case of medium load

A

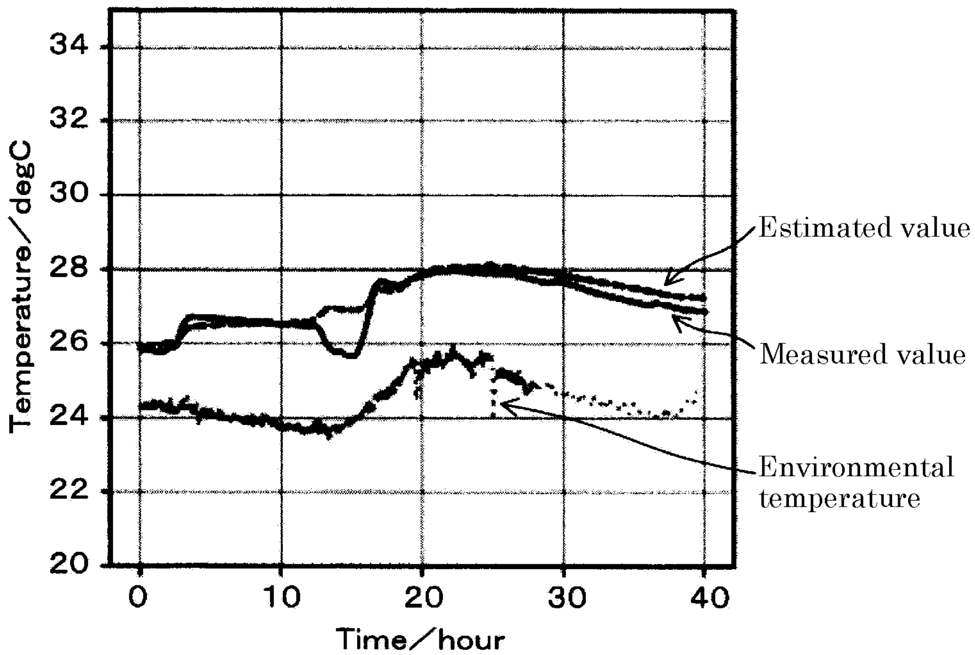


B

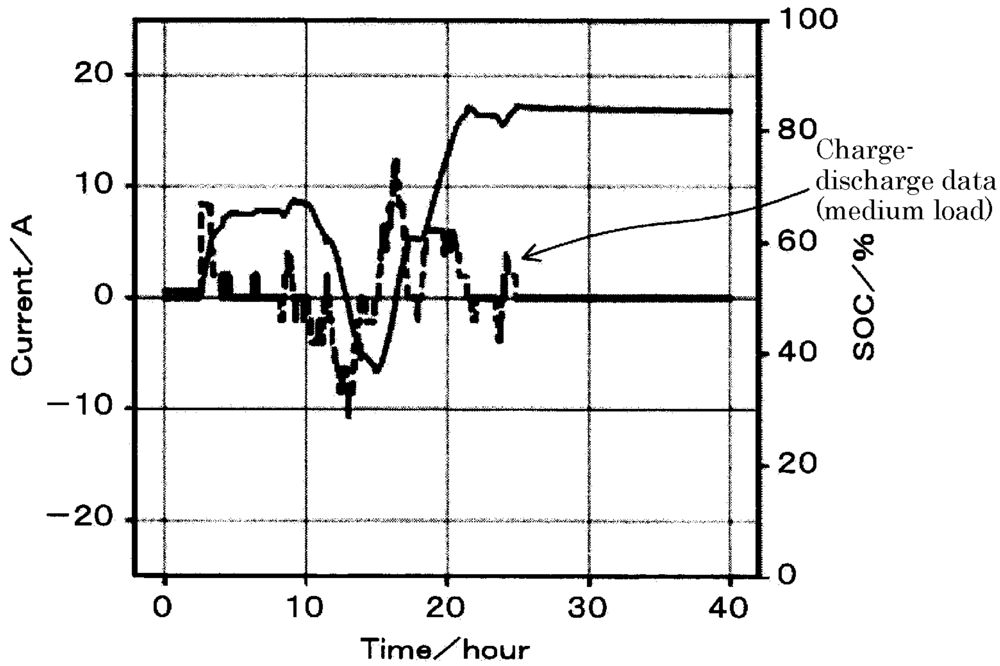

Fig. 12

Case of large load

A

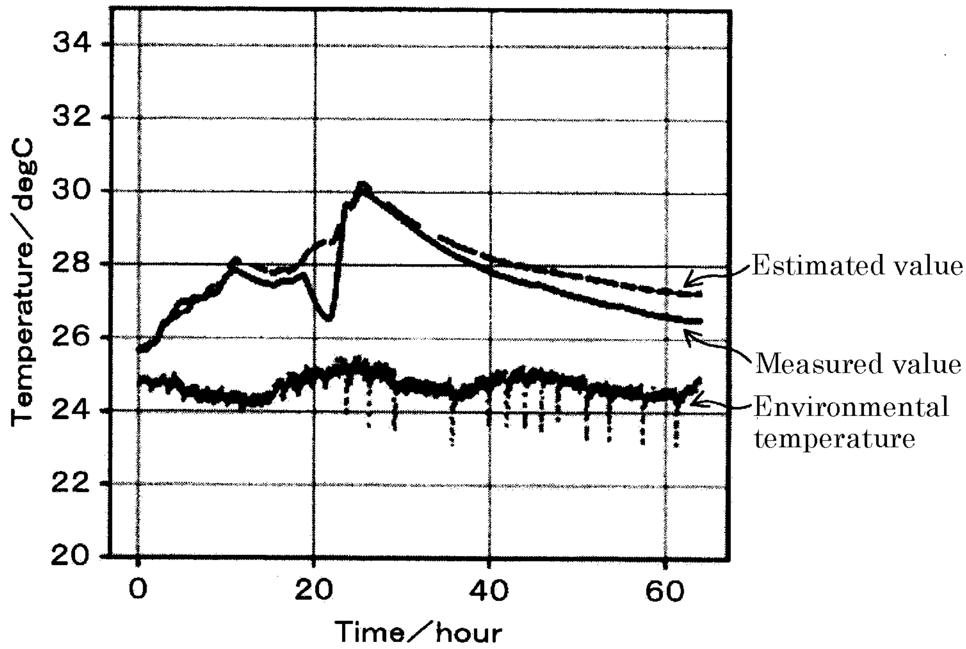


B

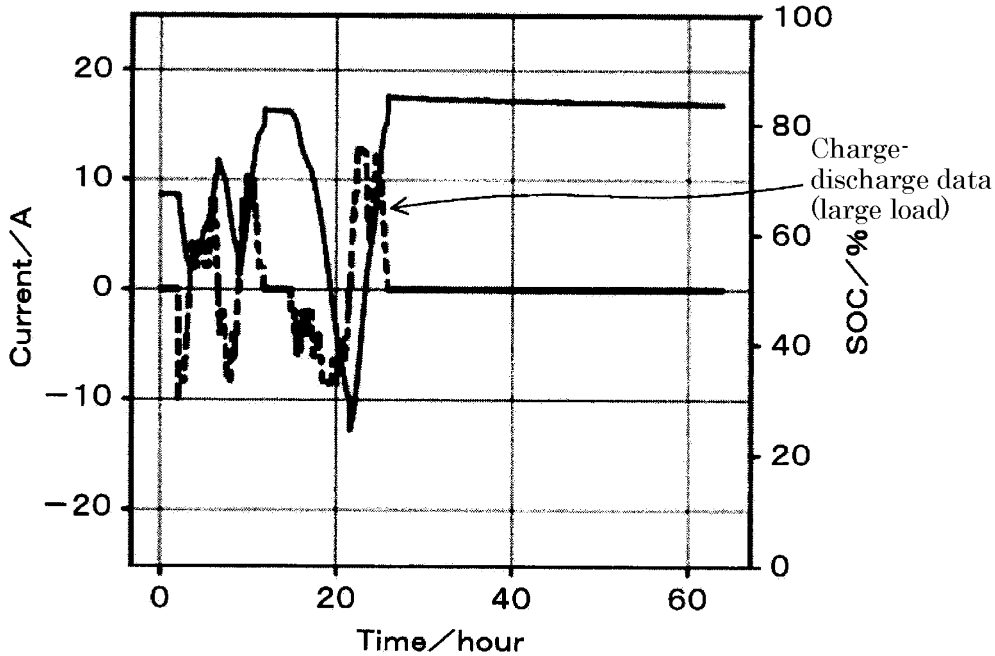

Fig. 13

Case of capacity checking test

A

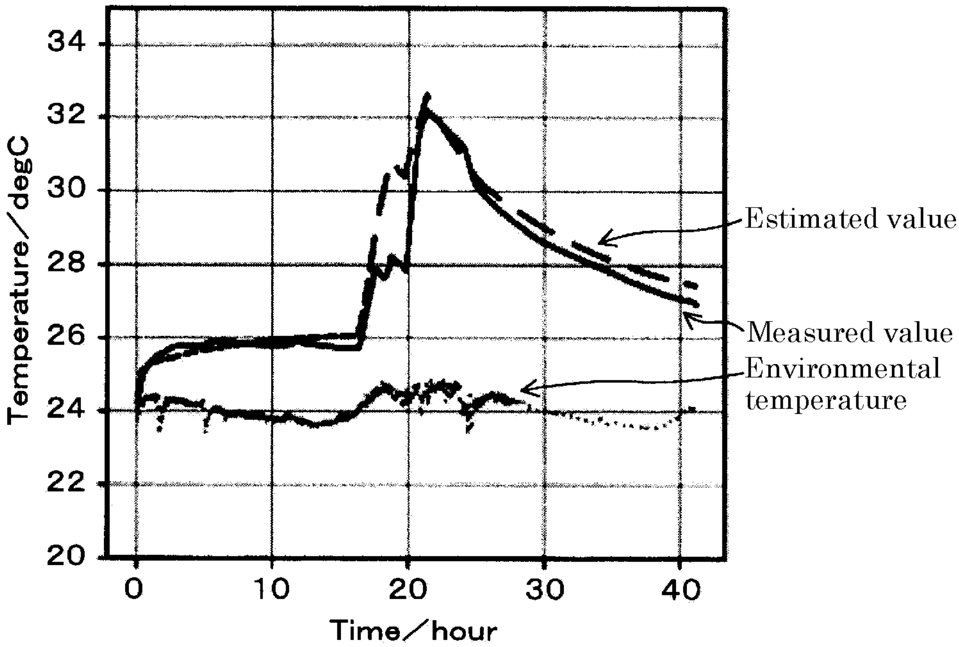


B

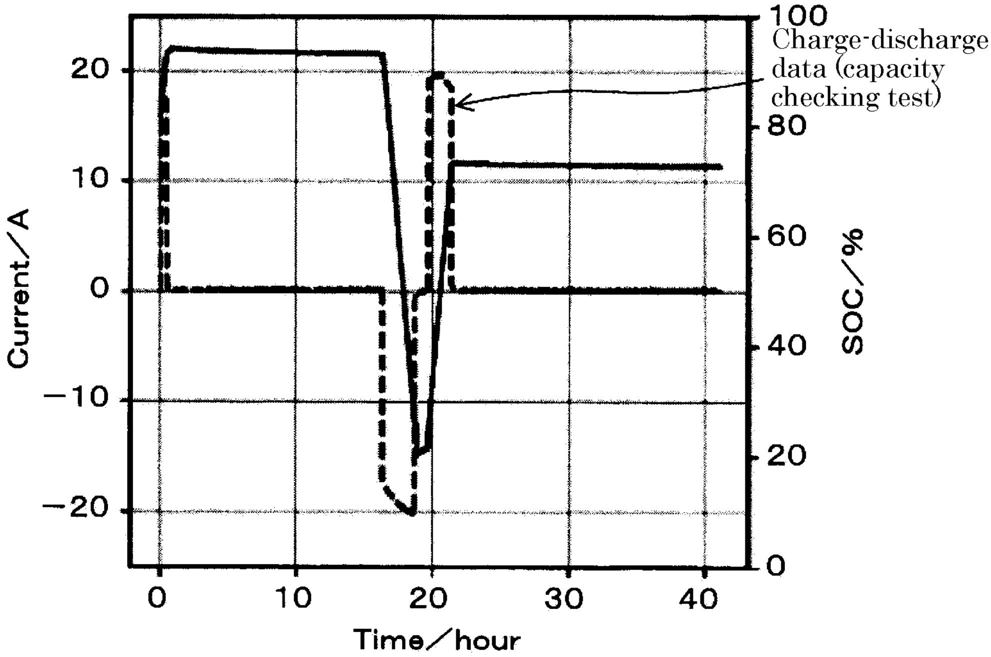

Fig. 14

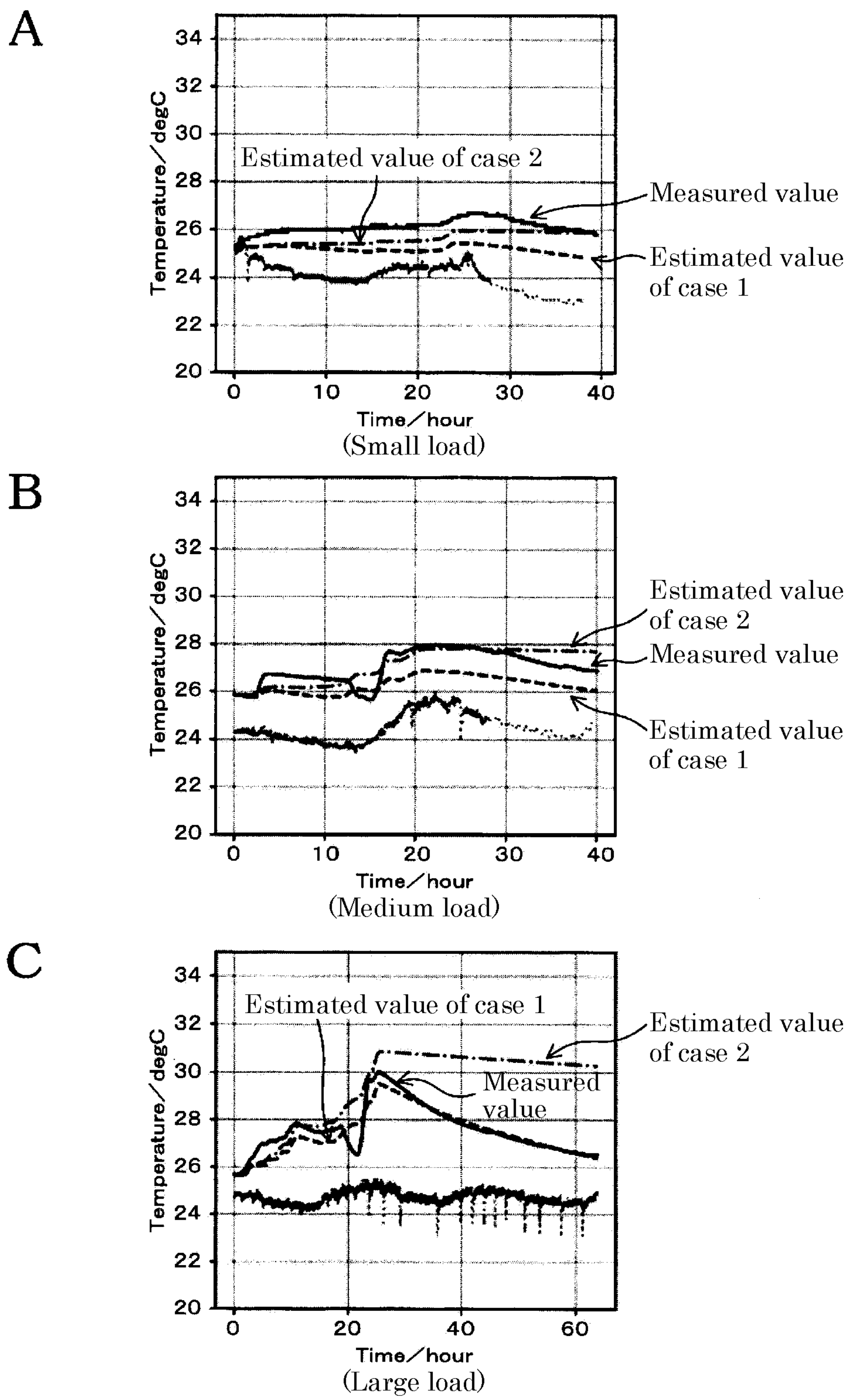
A
Temperature／degC
Time／hour
Estimated value of case 2
Measured value
Estimated value of case 1
(Small load)
B
Temperature／degC
Time／hour
Estimated value of case 2
Measured value
Estimated value of case 1
(Medium load)
C
Temperature／degC
Time／hour
Estimated value of case 1
Estimated value of case 2
Measured value
(Large load)

Fig. 15

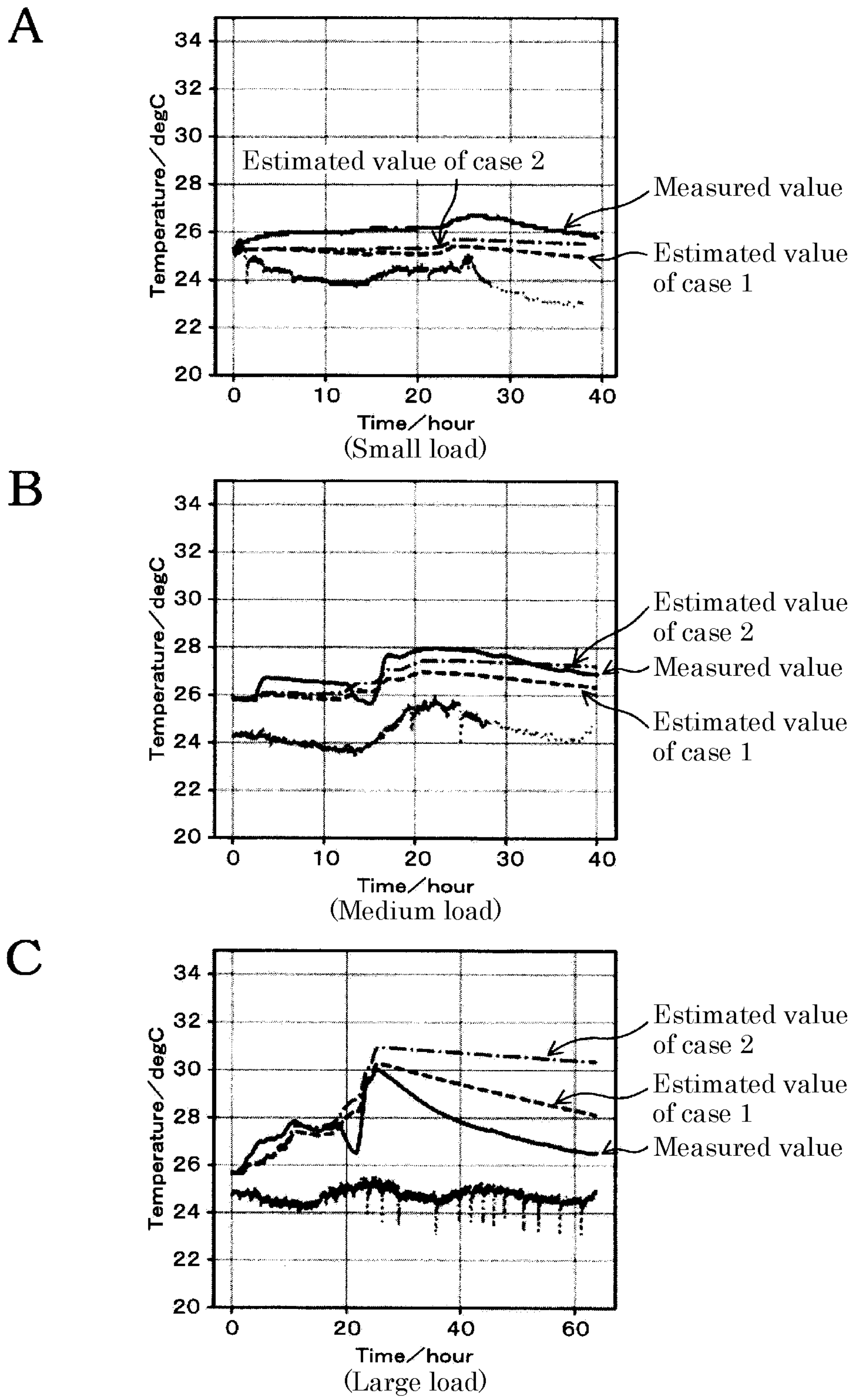
A
Temperature／degC
34
32
30
28
26
24
22
20
0
10
20
30
40
Time／hour
Estimated value of case 2
Measured value
Estimated value of case 1
(Small load)
B
Temperature／degC
34
32
30
28
26
24
22
20
0
10
20
30
40
Time／hour
Estimated value of case 2
Measured value
Estimated value of case 1
(Medium load)
C
Temperature／degC
34
32
30
28
26
24
22
20
0
20
40
60
Time／hour
Estimated value of case 2
Estimated value of case 1
Measured value
(Large load)

## INTERNATIONAL SEARCH REPORT

International application No.
PCT/JP2021/023213

A. CLASSIFICATION OF SUBJECT MATTER
H01M 10/48(2006.01)i
FI: H01M10/48 301; H01M10/48 P

According to International Patent Classification (IPC) or to both national classification and IPC

B. FIELDS SEARCHED

Minimum documentation searched (classification system followed by classification symbols)
H01M10/42-10/48; H02J7/00-7/12; H02J7/34-7/36; G01R31/36-31/396

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2018/025965 A1 (GS YUASA INTERNATIONAL LTD.) 08 February 2018 (2018-02-08) paragraphs [0012]-[0123], fig. 1-13 | 1-8 |
| A | WO 2014/118911 A1 (MITSUBISHI ELECTRIC CORP.) 07 August 2014 (2014-08-07) paragraphs [0010]-[0044], fig. 1-6 | 1-8 |
| A | WO 2016/038658 A1 (TOSHIBA CORP.) 17 March 2016 (2016-03-17) paragraphs [0014]-[0059], fig. 1-14 | 1-8 |
| A | JP 2019-129004 A. (TOYOTA MOTOR CORP.) 01 August 2019 (2019-08-01) paragraphs [0010]-[0042], fig. 1-4 | 1-8 |

☐ Further documents are listed in the continuation of Box C.

☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 August 2021 (16.08.2021) | 24 August 2021 (24.08.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/023213

| Patent Documents referred in the Report | Publication Date | Patent Family | Publication Date |
|---|---|---|---|
| WO 2018/025965 A1 | 08 Feb. 2018 | US 2019/0195958 A1 paragraphs [0028]-[0134], fig. 1-13<br>DE 112017003927 T5<br>CN 109565088 A | |
| WO 2014/118911 A1 | 07 Aug. 2014 | US 2015/0331059 A1 paragraphs [0027]-[0057], fig. 1-6<br>EP 2952920 A1<br>CA 2897468 A1<br>AU 2013376245 A1<br>RU 2015136562 A | |
| WO 2016/038658 A1 | 17 Mar. 2016 | US 2016/0380313 A1 paragraphs [0027]-[0073], fig. 1-14<br>TW 201610454 A | |
| JP 2019-129004 A | 01 Aug. 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2015151652 A